# EUROPEAN PATENT APPLICATION

(11) **EP 4 775 712 A1**
(43) Date of publication of application: **15.07.2026**
(21) Application number: 26150460.9
(22) Date of filing: 07.01.2026
(51) Int. Cl.: C25B 15/00, G01R 31/389, G01R 31/392

(54) **DIAGNOSIS METHOD OF ELECTROLYSIS UNIT, DIAGNOSIS APPARATUS OF ELECTROLYSIS UNIT, OPERATION SYSTEM, AND DIAGNOSIS PROGRAM OF ELECTROLYSIS UNIT**

(30) Priority: 09.01.2025 JP 2025003502
(71) Applicant: KABUSHIKI KAISHA TOSHIBA, Kawasaki-shi, Kanagawa (JP)
(72) Inventor: YAMASHITA, Tomohiro, Kawasaki-shi, Kanagawa (JP); UNO, Wataru, Kawasaki-shi, Kanagawa (JP); MORIMOTO, Sayaka, Kawasaki-shi, Kanagawa (JP); YAGI, Ryosuke, Kawasaki-shi, Kanagawa (JP); YAMAGIWA, Masakazu, Kawasaki-shi, Kanagawa (JP); FUJIWARA, Naoya, Kawasaki-shi, Kanagawa (JP); YONETSU, Maki, Kawasaki-shi, Kanagawa (JP)
(74) Representative: Hoffmann Eitle

(57) **Abstract**

In one approach, in a diagnosis method of an electrolysis unit (2), an impedance of the electrolysis unit (2) is measured in each of a first frequency range (ΔF1) and a second frequency range (ΔF2) lower in frequency than the first frequency range (ΔF1). In the diagnosis method, a resistance value of each of a first resistance component (R1) in which influence on the impedance becomes dominant in a first frequency range (ΔF1) and a second resistance component (R2) in which influence on the impedance becomes dominant in a second frequency range (ΔF2) is calculated based on measurement results of the impedance, and degradation and operation of the electrolysis unit (2) are determined based at least on a calculation result of each of the resistance values of the first resistance component (R1) and the second resistance component (R2).

## Description

### FIELD

Disclosures described herein relate generally to a diagnosis method of an electrolysis unit, a diagnosis apparatus of the electrolysis unit, an operation system, and a diagnosis program of the electrolysis unit.

### BACKGROUND

An electrolysis unit is used in which an electrochemical reaction using a feedstock occurs by input of electric power in a state in which the feedstock is supplied. For example, in an electrolysis unit (carbon dioxide electrolysis unit) to which carbon dioxide is supplied as a feedstock, electrolysis of carbon dioxide occurs as an electrochemical reaction by input of electric power. Then, a carbon compound such as carbon monoxide is generated as a product by the electrochemical reaction in the electrolysis unit, and the generated carbon compound is recovered.

In the electrolysis unit as described above, when the operation is continued, degradation occurs in the membrane, the cathode, and the like. In a state where the electrolysis unit is operated, an operational abnormality such as overheating may occur in the electrolysis unit. For this reason, in a state where the electrolysis unit is operated, for example, it is required to appropriately grasp the degradation state and the operation status of the electrolysis unit by appropriately grasping the occurrence of degradation of the membrane, the cathode, and the like, operational abnormality, and the like.

### BRIEF DESCRIPTION OF DRAWINGS

FIG. 1 is a schematic diagram illustrating an example of an operation system according to a first approach.
FIG. 2 is a flowchart schematically illustrating an example of processing of estimating a resistance component of an electrolysis unit performed by a processing circuit or the like in the first approach.
FIG. 3 is a schematic diagram illustrating an example of an equivalent circuit of an equivalent circuit model used for calculation of a plurality of resistance components of an electrolysis unit in the first approach.
FIG. 4 is a schematic diagram illustrating an example of processing of estimating a plurality of resistance components of an electrolysis unit performed by a processing circuit and the like in the first approach.
FIG. 5 is a flowchart schematically illustrating an example of determination processing regarding degradation and operation of the electrolysis unit performed by the processing circuit and the like in the first approach.
FIG. 6 is a flowchart schematically illustrating an example of determination processing regarding degradation of a membrane and a cathode, which is performed by a processing circuit and the like in the determination processing of the example of FIG. 5.
FIG. 7 is a flowchart schematically illustrating an example of deriving processing of deriving a degree of degradation or the like of a membrane of an electrolysis unit performed by a processing circuit and the like in the first approach.
FIG. 8 is a flowchart schematically illustrating an example of deriving processing of deriving a degree of degradation or the like of a cathode of an electrolysis unit performed by a processing circuit and the like in the first approach.
FIG. 9 is a schematic diagram for describing an example of processing of deriving a degree of degradation of a membrane of an electrolysis unit performed by a processing circuit and the like in the first approach.
FIG. 10 is a schematic diagram for describing an example of processing of calculating a difference between a temporary change rate and a change rate for a resistance component (second resistance component) of an electrolysis unit, the processing being performed by a processing circuit and the like in the first approach.
FIG. 11 is a schematic diagram for describing an example of processing of deriving a degree of degradation of a cathode of an electrolysis unit performed by a processing circuit and the like in the first approach.
FIG. 12 is a flowchart schematically illustrating an example of deriving processing of deriving a degree of degradation or the like of the cathode of the electrolysis unit, performed by a processing circuit and the like in a case where the degradation of the cathode is dominant and the influence of the degradation of the membrane is small in a certain modification.
FIG. 13 is a schematic diagram for describing an example of processing of deriving a degree of degradation of a cathode of an electrolysis unit performed by a processing circuit and the like in the modification of FIG. 12.

### DETAILED DESCRIPTION

According to one approach, a diagnosis method of an electrolysis unit is provided in which an electrochemical reaction using a feedstock occurs by input of electric power. In the diagnosis method, the impedance of the electrolysis unit is measured at one or more frequencies in each of a plurality of frequency ranges including a first frequency range and a second frequency range lower in frequency than the first frequency range. In the diagnosis method, a resistance value of each of a plurality of resistance components of the electrolysis unit including a first resistance component in which influence on the impedance of the electrolysis unit becomes dominant in a first frequency range and a second resistance component in which influence on the impedance becomes dominant in a second frequency range is calculated based on measurement results of the impedance in the plurality of frequency ranges, and degradation and operation of the electrolysis unit are determined based at least on a calculation result of each of the resistance values of the first resistance component and the second resistance component.

Hereinafter, an approach will be described with reference to the drawings.

### (First Approach)

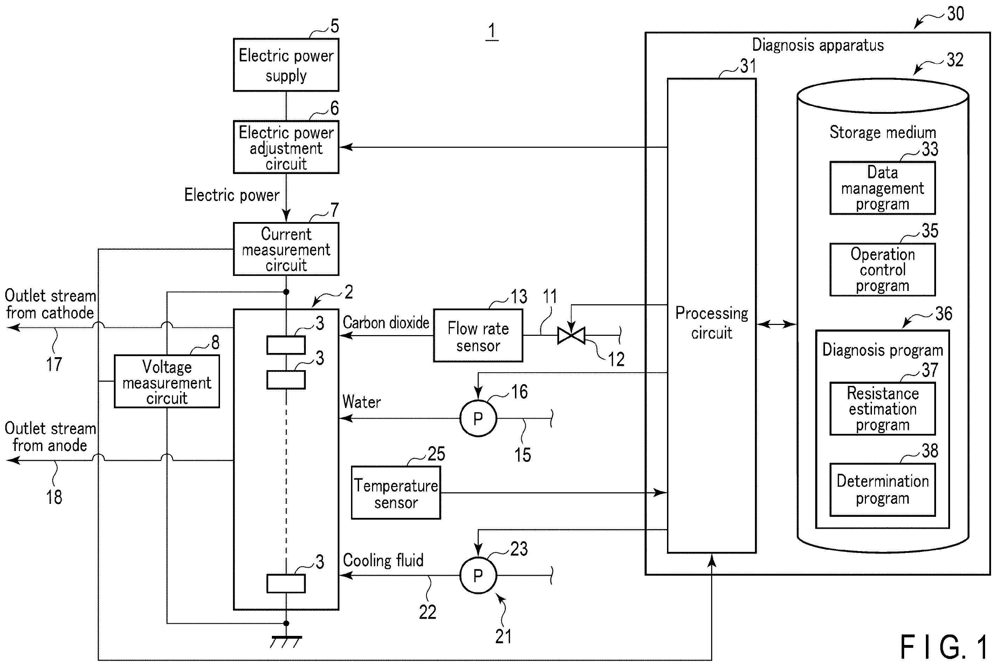

First, as an example of an approach, a first approach will be described. FIG. 1 is a schematic diagram illustrating an example of an operation system 1 according to the first approach. As illustrated in FIG. 1, the operation system 1 includes an electrolysis unit 2, and the electrolysis unit 2 is operated in the operation system 1. In the example of FIG. 1, the electrolysis unit 2 is composed of an electrolysis block or an electrolysis module to which a plurality of electrolysis cells 3 are electrically connected. In the electrolysis unit 2, at least one of a series connection structure in which a plurality of electrolysis cells 3 are electrically connected in series and a parallel connection structure in which a plurality of electrolysis cells 3 are electrically connected in parallel is formed. In one example, the electrolysis unit 2 may be formed of a single electrolysis cell 3.

The electrolysis cell 3 constituting the electrolysis unit 2 includes a cathode and an anode. In the electrolysis cell 3, a membrane such as a porous membrane, an ion exchange membrane, or an electrolyte membrane is interposed between the cathode and the anode. In one example, a porous membrane made of a resin is used as the membrane. In this case, examples of the resin that forms the membrane include polyethersulfone (PES). In the present approach, each of the one or more electrolysis cells 3 is a carbon dioxide electrolysis cell that electrolyzes carbon dioxide supplied as a feedstock, and the electrolysis unit 2 is a carbon dioxide electrolysis unit composed of one or more carbon dioxide electrolysis cells. In each of the electrolysis cells 3, a cathode serving as a reduction electrode is formed of, for example, any of a metal material and a carbon material, and an anode serving as an oxidation electrode is formed of, for example, any of a metal material, a carbon material, and a transparent conductive oxide.

In each of the electrolysis cells 3, each of the cathode and the anode includes a catalyst. As the catalyst of the cathode, any of a metal complex such as a ruthenium complex or a rhenium complex, an organic molecule having an imidazole skeleton or a pyridine skeleton, and the like is used. As the catalyst for the anode, metals such as ruthenium, iridium, platinum, cobalt, nickel, iron, and manganese can be used. As the catalyst for the anode, a binary metal oxide, a ternary metal oxide, and a quaternary metal oxide can be used, and a metal hydroxide containing cobalt, nickel, iron, manganese, or the like as a metal, and a metal complex such as a ruthenium complex or an iron complex can be used.

The electrolysis unit 2 can be electrically connected to an electric power supply 5, and the electrolysis unit 2 is operated by electric power from the electric power supply 5. Therefore, during operation of the electrolysis unit 2, electric power from the electric power supply 5 is input to the electrolysis unit 2. The electric power supply 5 may be a commercial electric power supply, or may be any of a storage battery, a fuel cell, and the like. In addition, the electric power supply 5 may be a generator that generates electric power using natural energy such as sunlight and wind power. In one example, electric power from the electric power supply 5 is supplied to the electrolysis unit 2 via the electric power system. In this case, examples of the electric power system between the electric power supply 5 and the electrolysis unit 2 include an electric power system that supplies electric power from a generator that generates electric power using natural energy, an electric power system that supplies electric power from an electric power plant, and the like.

The operation system 1 is provided with an electric power adjustment circuit 6 such as a power conditioner. The electric power adjustment circuit 6 converts electric power from the electric power supply 5, and inputs the converted electric power to the electrolysis unit 2. At this time, the electric power adjustment circuit 6 converts, for example, AC electric power from the electric power supply 5 into DC electric power in a voltage range corresponding to the electrolysis unit 2 by AC/DC conversion and transformation. Then, the electric power adjustment circuit 6 inputs the converted DC electric power to the electrolysis unit 2 as operating electric power for operating the electrolysis unit 2. In addition, in the operation system 1, the magnitude of the electric power input to the electrolysis unit 2 changes in accordance with the operating state of the electric power adjustment circuit 6. Therefore, the magnitude of the current input to the electrolysis unit 2 and the magnitude of the voltage applied to the electrolysis unit 2 change in accordance with the operating state of the electric power adjustment circuit 6, and the current and the voltage of the electrolysis unit 2 are adjusted by the electric power adjustment circuit 6.

In the operation of the electrolysis unit 2 which is a carbon dioxide electrolysis unit, electric power is input to the electrolysis unit 2 in a state in which a feedstock containing carbon dioxide and water is supplied to the electrolysis unit 2. In a state in which the feedstock is supplied, electric power is input to the electrolysis unit 2, whereby an electrochemical reaction using the feedstock occurs in the electrolysis unit 2. In the example of FIG. 1, when electric power is input to the electrolysis unit 2, in each of the electrolysis cells 3 constituting the electrolysis unit 2, electrolysis of carbon dioxide at the cathode and electrolysis of water at the anode occur as electrochemical reactions. In a state in which an electrochemical reaction occurs in the electrolysis unit 2 by the input of electric power to the electrolysis unit 2, in each of the electrolysis cells 3 constituting the electrolysis unit 2, the anode has a relatively higher electric potential than the cathode. At this time, in each of the electrolysis cells 3, the electric potentials of the cathode and the anode change in accordance with the material constituting the electrode, the operating conditions of the electrolysis unit 2, and the like.

In a state in which the electrolysis unit 2 is operated, carbon dioxide as a feedstock is reduced by electrolysis of carbon dioxide at each cathode of the electrolysis cell 3. Thereby, at least a carbon compound is generated at each cathode of the electrolysis cell 3. Examples of the carbon compound generated in the cathode by the electrolysis of carbon dioxide include carbon monoxide, formic acid, methanol, methane, ethanol, ethane, and ethylene. The carbon compound that is the product of the electrolysis of carbon dioxide at the cathode is recovered. In addition, in a state in which the electrolysis unit 2 is operated, water as a feedstock is oxidized by electrolysis of water at each anode of the electrolysis cell 3. As a result, at least oxygen or hydrogen peroxide water is generated as an oxide by the oxidation reaction of water in each anode of the electrolysis cell 3. Oxygen or the like, which is a product obtained by electrolysis of water at the anode, is recovered.

The operation system 1 is provided with a current measurement circuit 7 and a voltage measurement circuit 8. The current measurement circuit 7 includes, for example, a current sensor or the like, and the voltage measurement circuit 8 includes, for example, a voltage sensor or the like. In a state in which electric power is input to the electrolysis unit 2 or the like, the current measurement circuit 7 measures a current of the electrolysis unit 2, that is, a current input to the electrolysis unit 2. In addition, in a state in which electric power is input to the electrolysis unit 2 or the like, the voltage measurement circuit 8 measures a voltage of the electrolysis unit 2, that is, a voltage applied to the electrolysis unit 2.

In the operation system 1, a gas supply channel 11 is connected to the electrolysis unit 2, and an adjustment valve 12 serving as a supply amount adjustment unit and a flow rate sensor 13 are disposed in the gas supply channel 11. In the operation system 1, a source gas containing carbon dioxide is stored in a gas tank (not illustrated) or the like. When the adjustment valve 12 is opened, the source gas is supplied from the gas tank to the electrolysis unit 2 through the gas supply channel 11. As a result, carbon dioxide is supplied as a feedstock to each cathode of the electrolysis cell 3. In the operation system 1, the flow rate of the source gas in the gas supply channel 11 changes in accordance with the opening degree of the adjustment valve 12. Therefore, the supply amount of the source gas to the electrolysis unit 2 changes in accordance with the operating state of the adjustment valve 12 which is the supply amount adjustment unit, and the supply amount of carbon dioxide as a feedstock to the electrolysis unit 2 changes. The flow rate sensor 13 detects the flow rate of the source gas between the adjustment valve 12 and the electrolysis unit 2 in the gas supply channel 11. As a result, the supply amount of the source gas to the electrolysis unit 2 is detected by the flow rate sensor 13.

In the operation system 1, a water supply channel 15 is connected to the electrolysis unit 2, and a supply pump 16 serving as a supply amount adjustment unit is disposed in the water supply channel 15. In the operation system 1, water is stored in a water tank (not illustrated) or the like. When the supply pump 16 is operated, water is supplied from the water tank to the electrolysis unit 2 through the water supply channel 15. As a result, water is supplied as a feedstock to each anode of the electrolysis cell 3. In the operation system 1, the amount of water supplied to the electrolysis unit 2 changes in accordance with the operating state of the supply pump 16.

In addition, in the operation system 1, each of discharge channels 17 and 18 is connected to the electrolysis unit 2. In the electrolysis unit 2, outlet streams from the respective cathodes of the electrolysis cells 3 are discharged through the discharge channel 17 and outlet streams from the respective anodes of the electrolysis cells 3 are discharged through the discharge channel 18. The outlet streams from the cathode include carbon compounds that are products from the electrolysis of carbon dioxide. In the discharge channel 17, the products from the electrolysis of carbon dioxide are separated from other outlet streams. This makes it possible to recover a carbon compound which is a product obtained by electrolysis of carbon dioxide. In addition, the outlet streams from the anode include oxygen or the like which is a product obtained by electrolysis of water. In the discharge channel 18, a product resulting from electrolysis of water is separated from other outlet streams. This makes it possible to recover a product by electrolysis of water.

In addition, the operation system 1 includes a temperature adjustment unit 21, and in the example of FIG. 1, the temperature adjustment unit 21 includes a cooling fluid channel 22 and a supply pump 23. In the temperature adjustment unit 21, the cooling fluid channel 22 is connected to the electrolysis unit 2, and the supply pump 23 is disposed in the cooling fluid channel 22. In the temperature adjustment unit 21, when the supply pump 23 operates, cooling fluid such as cooling gas or cooling water is supplied to the electrolysis unit 2 through the cooling fluid channel 22. In the temperature adjustment unit 21, the supply amount of the cooling fluid to the electrolysis unit 2 changes in accordance with the operating state of the supply pump 23. The temperature adjustment unit 21 adjusts a temperature of the electrolysis unit 2 by adjusting a supply amount of the cooling fluid to the electrolysis unit 2. In one example, the temperature adjustment unit 21 includes a heat exchanger. In this case, a cooling fluid channel through which cooling fluid such as cooling water or cooling gas flows is provided in the operation system 1. In the temperature adjustment unit 21, the heat exchanger adjusts the temperature of the electrolysis unit 2 by transferring heat between the cooling fluid flowing in the cooling fluid channel and the electrolysis unit 2. In the example of FIG. 1, the operation system 1 includes a temperature sensor 25, and the temperature sensor 25 detects the temperature of the electrolysis unit 2.

In the present approach, the operation system 1 includes a diagnosis apparatus 30 serving as a processing apparatus. The diagnosis apparatus 30 performs processing related to diagnosis of the operating electrolysis unit 2. Therefore, in the operation system 1, the electrolysis unit 2 is a diagnosis target of diagnosis by the diagnosis apparatus 30. In the example of FIG. 1, the diagnosis apparatus 30 is constituted by a computer such as a server, and includes a processing circuit 31 and a storage medium (non-transitory storage medium) 32. The processing circuit 31 includes a processor, an integrated circuit, or the like, and the processor or the like constituting the processing circuit 31 includes any of a central processing unit (CPU), an application specific integrated circuit (ASIC), a microcomputer, a field programmable gate array (FPGA), a digital signal processor (DSP), and the like. The processing circuit 31 may include one processor or the like, or may include a plurality of processors or the like. Furthermore, the storage medium 32 may be a main storage medium such as a memory, or may be an auxiliary storage medium. In the diagnosis apparatus 30, only one storage medium 32 may be provided, or a plurality of storage media may be provided.

In the diagnosis apparatus 30, the processing circuit 31 performs processing by executing a program or the like stored in the storage medium 32. Furthermore, the storage medium 32 stores data and the like used for processing in the processing circuit 31. In one example, in the diagnosis apparatus 30, the program executed by the processing circuit 31 may be stored in a computer (server) connected via a network such as the Internet, a server in a cloud environment, or the like. In this case, the processing circuit 31 downloads the program via the network.

In the example of FIG. 1, the storage medium 32 stores a data management program 33, an operation control program 35, and a diagnosis program 36 as programs to be executed by the processing circuit 31. The processing circuit 31 executes the data management program 33 to write data to the storage medium 32 and read data from the storage medium 32. In a state in which the electrolysis unit 2 is operated, the processing circuit 31 performs operation control described later related to the operation of the electrolysis unit 2 based on the operation control program 35. The diagnosis program 36 includes a resistance estimation program 37 and a determination program 38. In the diagnosis of the electrolysis unit 2, the processing circuit 31 performs processing to be described later based on the diagnosis program 36.

Note that, in an example, the diagnosis apparatus 30 is constituted by a plurality of computers such as a plurality of servers, and processors of the plurality of computers cooperate to perform operation control to be described later based on the operation control program 35, processing to be described later based on the diagnosis program 36, and the like. In a case where the diagnosis apparatus 30 is constituted by a plurality of computers, the plurality of computers constituting the diagnosis apparatus 30 can communicate with each other wirelessly or by wire. In another example, at least a part of the diagnosis apparatus 30 is configured from a cloud server in a cloud environment. The infrastructure of the cloud environment includes a virtual processor such as a virtual CPU and a cloud memory. In a case where at least a part of the diagnosis apparatus 30 is constituted by a cloud server, a virtual processor performs at least a part of operation control to be described later based on the operation control program 35, processing to be described later based on the diagnosis program 36, and the like. In addition, a program executed by the virtual processor, data used for processing in the virtual processor, and the like are stored in the cloud memory.

In one example, the diagnosis apparatus 30 may be provided with a user interface. In this case, in the user interface, various operations including operations related to the operation and diagnosis of the electrolysis unit 2 are input by the user or the like of the operation system 1. Therefore, in the user interface, any of a button, a mouse, a touch panel, a keyboard, and the like is provided as an operation unit to which an operation is input by the user or the like. In addition, the user interface is provided with a notifier that notifies information related to the electrolysis unit 2. The notifier notifies information by any of screen display, transmission of sound, and the like. Note that the user interface may be provided separately from a computer or the like constituting the diagnosis apparatus 30. Furthermore, the user interface is not necessarily provided.

In the example of FIG. 1, the processing circuit 31 and the like of the diagnosis apparatus 30 perform operation control related to the operation of the electrolysis unit 2 as follows based on the operation control program 35. That is, in a state in which the electrolysis unit 2 is operated, the processing circuit 31 and the like acquire the measurement result of the current of the electrolysis unit 2 in the current measurement circuit 7 and the measurement result of the voltage of the electrolysis unit 2 in the voltage measurement circuit 8. Then, the processing circuit 31 and the like control the operation of the electric power adjustment circuit 6 based on the measurement results of the current and the voltage of the electrolysis unit 2, and adjust the magnitude or the like of the operating electric power input to the electrolysis unit 2. As a result, an operating current input to the electrolysis unit 2, a voltage applied to the electrolysis unit 2, and the like are adjusted.

In the example of FIG. 1, the processing circuit 31 and the like acquire a detection result of the supply amount of the source gas in the flow rate sensor 13. Then, the processing circuit 31 and the like control the operation of the adjustment valve 12 based on the detection result of the supply amount of the source gas to the electrolysis unit 2 to adjust the supply amount of the source gas to the electrolysis unit 2. Thus, the supply amount of carbon dioxide to the electrolysis unit 2 is adjusted. The processing circuit 31 and the like control the operation of the supply pump 16 to adjust the amount of water supplied to the electrolysis unit 2. The processing circuit 31 and the like acquire a detection result of the temperature of the electrolysis unit 2 by the temperature sensor 25. Then, the processing circuit 31 and the like control the operation of the temperature adjustment unit 21 based on the detection result of the temperature of the electrolysis unit 2 to adjust the temperature of the electrolysis unit 2.

In the present approach, the processing circuit 31 and the like execute the diagnosis program 36, so that the diagnosis processing is repeated over time for the operating electrolysis unit 2. In one example, the diagnosis processing is periodically performed on the electrolysis unit 2 to be diagnosed. In one diagnosis processing for the electrolysis unit 2, the resistance component estimation processing of the electrolysis unit 2 is performed by executing the resistance estimation program 37 included in the diagnosis program 36. In one diagnosis processing for the electrolysis unit 2, after the resistance component estimation processing is performed, the determination program 38 included in the diagnosis program 36 is executed, so that the determination processing based on the estimation result of the resistance component is performed for the electrolysis unit 2. In the determination processing for the electrolysis unit 2, determination is made on the degradation and operation of the electrolysis unit 2. As the diagnosis processing as described above is repeatedly performed over time, the estimation processing of the resistance component and the determination processing regarding the degradation and the operation are repeatedly performed over time for the operating electrolysis unit 2.

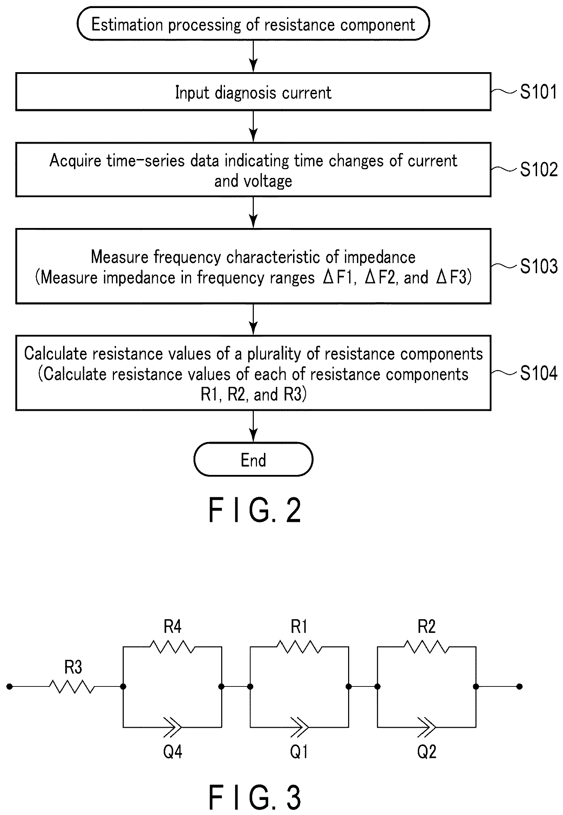

FIG. 2 is a flowchart schematically illustrating an example of resistance component estimation processing of the electrolysis unit 2 performed by the processing circuit 31 and the like in the first approach. The estimation processing in the example of FIG. 2 is performed before the determination processing to be described later regarding the degradation and operation of the electrolysis unit 2 is executed in each diagnosis processing for the electrolysis unit 2 repeatedly performed over time. When the processing of the example of FIG. 2 is started, the processing circuit 31 and the like control the operation of the electric power adjustment circuit 6 to input a diagnosis current from the electric power adjustment circuit 6 to the electrolysis unit 2 (S101). The diagnosis current is a current signal corresponding to the measurement of the impedance of the electrolysis unit 2.

In one example, as a diagnosis current, an alternating current with a periodically changing current value is input to the electrolysis unit 2. In this case, the alternating current is input to the electrolysis unit 2 with any waveform such as a sine wave, a triangular wave, or a sawtooth wave. In a case where the alternating current is generated as a diagnosis current, the processing circuit 31 and the like adjust the frequency of the alternating current input to the electrolysis unit 2 by, for example, controlling the operation of the electric power adjustment circuit 6. Then, the processing circuit 31 and the like input an alternating current to be a diagnosis current to the electrolysis unit 2 in a state in which the alternating current changes to a plurality of frequencies with time. In another example, a pseudo random pulse signal such as an M-sequence signal is input to the electrolysis unit 2 as a diagnosis current. In this case, the pseudo random pulse signal input to the electrolysis unit 2 includes a plurality of types of pulses having different pulse widths from each other.

Then, in a state in which the diagnosis current is input to the electrolysis unit 2, the processing circuit 31 and the like cause the current measurement circuit 7 to measure the current of the electrolysis unit 2, and cause the voltage measurement circuit 8 to measure the voltage of the electrolysis unit 2. Then, the processing circuit 31 and the like acquire time-series data indicating time changes (time history) of the current and the voltage of the electrolysis unit 2 in a state in which the diagnosis current is input to the electrolysis unit 2 (S102). The time change in the current of the electrolysis unit 2 indicated by the time-series data is generated based on the measurement result in the current measurement circuit 7, and the time change in the voltage of the electrolysis unit 2 indicated by the time-series data is generated based on the measurement result in the voltage measurement circuit 8.

In one example, the processing circuit 31 and the like, for example, control the operation of the electric power adjustment circuit 6, and a diagnosis current corresponding to the measurement of the impedance is superimposed on the operating current input to the electrolysis unit 2 in order to cause the electrochemical reaction to occur. In this case, in a state in which an operating current is input to the electrolysis unit 2, that is, in a state in which an electrochemical reaction occurs in the electrolysis unit 2 by the input of the operating electric power, a diagnosis current is input to the electrolysis unit 2. Therefore, in parallel with the operation of the electrolysis unit 2, the time-series data indicating the time changes of the current and the voltage of the electrolysis unit 2 in the state in which the diagnosis current is input is measured. In one example, an electric power supply circuit or the like is provided separately from the electric power adjustment circuit 6. In a state in which an operating current is input from the electric power adjustment circuit 6 to the electrolysis unit 2, a diagnosis current from another electric power supply circuit or the like is superimposed on the operating current.

When the above-described time-series data (measurement data) is acquired, the processing circuit 31 and the like measure the frequency characteristic of the impedance of the electrolysis unit 2 by analyzing the acquired time-series data (S103). When the time-series data is acquired, the input of the diagnosis current to the electrolysis unit 2 is stopped. In one example, in the measurement of the frequency characteristic of the impedance of the electrolysis unit 2, the time change of the current of the electrolysis unit 2 indicated by the above-described time-series data, that is, the current time-series data included in the time-series data is Fourier-transformed to generate current spectrum data indicating the frequency characteristic of the current of the electrolysis unit 2. The voltage spectrum data indicating the frequency characteristic of the voltage of the electrolysis unit 2 is generated by performing the Fourier transformation on the time change of the voltage of the electrolysis unit 2 indicated by the above-described time-series data, that is, the voltage time-series data included in the time-series data.

Then, calculation is performed using the current spectrum data and the voltage spectrum data of the electrolysis unit 2 to calculate impedance spectrum data indicating a frequency characteristic of the impedance of the electrolysis unit 2. The impedance spectrum data of the electrolysis unit 2 is calculated, for example, by dividing voltage spectrum data of the electrolysis unit 2 by the current spectrum data of the electrolysis unit 2. In the impedance spectrum data of the electrolysis unit 2, the impedance of the electrolysis unit 2 at each of the plurality of frequencies is indicated.

In one example, the processing circuit 31 and the like calculate an autocorrelation function of the current spectrum data of the electrolysis unit 2 and calculate a cross-correlation function between the current spectrum data and the voltage spectrum data of the electrolysis unit 2. Then, the processing circuit 31 and the like calculate the frequency characteristic of the impedance of the electrolysis unit 2 using the calculated autocorrelation function and cross-correlation function. In another example, an alternating current is input as a diagnosis current to the electrolysis unit 2 at a plurality of frequencies, and the processing circuit 31 and the like calculate the impedance of the electrolysis unit 2 based on the current value and the voltage value of the electrolysis unit 2 indicated by time-series data (measurement data) or the like for each of the plurality of frequencies. At this time, for example, the impedance of the electrolysis unit 2 is calculated by dividing the voltage value of the electrolysis unit 2 by the current value for each of the plurality of frequencies. As a result, the frequency characteristic of the impedance of the electrolysis unit 2 in which the impedance of the electrolysis unit 2 at each of the plurality of frequencies is indicated is calculated.

In the present approach, in the measurement of the frequency characteristic of the impedance of the electrolysis unit 2, the processing circuit 31 and the like measure the impedance of the electrolysis unit 2 in each of a plurality of frequency ranges different from each other. In each of the plurality of frequency ranges, the impedance of the electrolysis unit 2 is measured at one or more frequencies. In the example of FIG. 2, a frequency range (first frequency range) ΔF1 and a frequency range (second frequency range) ΔF2 lower in the frequency than the frequency range ΔF1 are included in a plurality of frequency ranges, and the impedance of the electrolysis unit 2 is measured at one or more frequencies in each of at least the frequency ranges ΔF1 and ΔF2.

In one example, the upper limit frequency of the frequency range ΔF2 matches the lower limit frequency of the frequency range ΔF1. In this case, for example, the frequency range ΔF1 is a frequency range of 1 Hz or more and 1 kHz or less, and corresponds to a medium frequency region. The frequency range ΔF2 is a frequency range of 0.01 Hz or more and 1 Hz or less, and corresponds to a low frequency region. In another example, none of the frequencies in the frequency range ΔF2 is included in the frequency range ΔF1, and there is no overlapping frequency between the frequency ranges ΔF1 and ΔF2. In this case, for example, the frequency range ΔF1 is a frequency range of 10 Hz or more and 100 Hz or less, and corresponds to a medium frequency region. The frequency range ΔF2 is a frequency range of 0.01 Hz or more and 1 Hz or less, and corresponds to a low frequency region.

In a preferred example such as the example of FIG. 2, the plurality of frequency ranges for measuring the impedance include a frequency range (third frequency range) ΔF3 higher in the frequency than the frequency range ΔF1, and the impedance of the electrolysis unit 2 is measured at one or more frequencies in the frequency range ΔF3 in addition to the frequency ranges ΔF1 and ΔF2. The frequency range ΔF3 is separated from the frequency ranges ΔF1 and ΔF2 to a higher frequency side. In addition, none of the frequencies in the frequency range ΔF3 is included in each of the frequency ranges ΔF1 and ΔF2, and there is no frequency overlapping the frequency ranges ΔF1 and ΔF2 in the frequency range ΔF3. In one example, the frequency range ΔF3 is a frequency range of 10 kHz or more and 100 kHz or less, and corresponds to an ultra-high frequency region.

In the present approach, in addition to the three frequency ranges ΔF1 to ΔF3, the impedance of the electrolysis unit 2 may be measured at one or more frequencies in one or more frequency ranges different from the frequency ranges ΔF1 to ΔF3. In one example, in addition to the three frequency ranges ΔF1 to ΔF3, the impedance of the electrolysis unit 2 is measured at one or more frequencies in a frequency range (fourth frequency range) ΔF4 between the frequency ranges ΔF1 and ΔF3. In this example, the frequency range ΔF4 is a frequency range higher in the frequency than the frequency ranges ΔF1 and ΔF2 and lower in the frequency than the frequency range ΔF3. For example, 1 Hz or more and 1 kHz or less is set in the frequency range ΔF1, 0.01 Hz or more and 1 Hz or less is set in the frequency range ΔF2, 10 kHz or more and 100 kHz or less is set in the frequency range ΔF3, and 1 kHz or more and 10 kHz or less is set in the frequency range ΔF4. In this case, the frequency range ΔF4 corresponds to a high frequency region, and any frequency in the frequency range ΔF4 is not included in the frequency range ΔF2. The lower limit frequency of the frequency range ΔF4 matches the upper limit frequency of the frequency range ΔF1, and the upper limit frequency of the frequency range ΔF4 matches the lower limit frequency of the frequency range ΔF3.

When the frequency characteristic of the impedance of the electrolysis unit 2 is measured, the processing circuit 31 and the like calculate the resistance value of each of the plurality of resistance components of the electrolysis unit 2 based on the measurement result of the frequency characteristic of the impedance for the electrolysis unit 2 (S104). Therefore, the resistance value of each of the plurality of resistance components is calculated based on the measurement results of the impedance in the plurality of frequency ranges including the frequency ranges ΔF1 and ΔF2. In the present approach, the plurality of resistance components whose resistance values are calculated include resistance components R1 and R2, and at least the resistance value of each of the resistance components R1 and R2 is calculated. In a preferred example such as the example of FIG. 2, the resistance value of the resistance component R3 is calculated in addition to the resistance components R1 and R2. In a more preferable example, the resistance value of the resistance component R4 is calculated as the plurality of resistance components in addition to the resistance components R1 to R3.

In the resistance component (first resistance component) R1, the influence on the impedance of the electrolysis unit 2 becomes dominant in the frequency range (first frequency range) ΔF1, and for example, the influence on the impedance of the electrolysis unit 2 becomes dominant in a medium frequency region of 1 Hz or more and 1 kHz or less. In the frequency characteristic of the impedance of the electrolysis unit 2, the resistance component R1 appears in the frequency range ΔF1, is higher than the frequency range in which the resistance component R2 appears, and appears in the frequency range lower than each of the frequency ranges in which the resistance components R3 and R4 appear. Therefore, the resistance component R1 has a response speed corresponding to the frequency range ΔF1, and the response speed of the resistance component R1 is faster than the response speed of the resistance component R2 and slower than the response speed of each of the resistance components R3 and R4. The resistance component R1 is, for example, a resistance component against activation of an electrochemical reaction by a catalyst.

The resistance component (second resistance component) R2 has a dominant influence on the impedance of the electrolysis unit 2 in the frequency range (second frequency range) ΔF2, and has a dominant influence on the impedance of the electrolysis unit 2 in a low frequency region of, for example, 0.01 Hz or more and 1 Hz or less. In the frequency characteristic of the impedance of the electrolysis unit 2, the resistance component R2 appears in the frequency range ΔF2, and appears in a frequency region lower than each of the frequency regions in which the resistance components R1, R3, and R4 appear. Therefore, the resistance component R2 has a response speed corresponding to the frequency range ΔF2, and the response speed of the resistance component R2 is slower than the response speed of each of the resistance components R1, R3, and R4. The resistance component R2 is, for example, a resistance component to diffusion of substances and gases.

In the resistance component (third resistance component) R3, the influence on the impedance of the electrolysis unit 2 becomes dominant in the frequency range (third frequency range) ΔF3, and for example, the influence on the impedance of the electrolysis unit 2 becomes dominant in an ultra-high frequency region of 10 kHz or more and 100 kHz or less. In the frequency characteristic of the impedance of the electrolysis unit 2, the resistance component R3 appears in the frequency range ΔF3, and appears in a frequency region higher than each of frequency regions in which the resistance components R1, R2, and R4 appear. Therefore, the resistance component R3 has a response speed corresponding to the frequency range ΔF3, and the response speed of the resistance component R3 is faster than the response speed of each of the resistance components R1, R2, and R4. The resistance component R3 is, for example, a resistance component corresponding to ohmic resistance, bulk resistance, and the like.

In the resistance component (fourth resistance component) R4, the influence on the impedance of the electrolysis unit 2 becomes dominant in the frequency range (fourth frequency range) ΔF4, and for example, the influence on the impedance of the electrolysis unit 2 becomes dominant in a high frequency region of 1 kHz or more and 10 kHz or less. In the frequency characteristic of the impedance of the electrolysis unit 2, the resistance component R4 appears in the frequency range ΔF4, and appears in a frequency region higher than each of the frequency regions in which the resistance components R1 and R2 appear, and lower than the frequency region in which the resistance component R3 appears. Therefore, the resistance component R4 has a response speed corresponding to the frequency range ΔF4, and the response speed of the resistance component R4 is faster than the response speed of each of the resistance components R1 and R2 and slower than the response speed of the resistance component R3. The resistance component R4 is, for example, a resistance component to diffusion of ions.

The resistance value of each of the plurality of resistance components of the electrolysis unit 2 including the resistance components R1 and R2 is calculated using, for example, the measurement result of the frequency characteristic of the impedance of the electrolysis unit 2 and the equivalent circuit model of the electrolysis unit 2. An equivalent circuit model of the electrolysis unit 2 is stored in the storage medium 32 or the like, and the equivalent circuit model indicates an equivalent circuit of the electrolysis unit 2. In the equivalent circuit of the equivalent circuit model, circuit parameters (electrical characteristic parameters) including a resistance component for which a resistance value is calculated are set. Therefore, in the equivalent circuit, the circuit parameters to be set include the resistance components R1 and R2, and in a preferred example, the circuit parameters to be set in the equivalent circuit include the four resistance components R1 to R4 described above.

FIG. 3 is a schematic diagram illustrating an example of an equivalent circuit of an equivalent circuit model used for calculating resistance values of a plurality of resistance components of the electrolysis unit 2 in the first approach. In the equivalent circuit of the example of FIG. 3, the above-described resistance components R1 to R4 are set as circuit parameters. Further, in the equivalent circuit of the example of FIG. 3, each of CPEs Q1, Q2, and Q4, which are CPEs (constant phase elements), is set as a circuit parameter. In each of the CPEs Q1, Q2, and Q4, capacitance corresponding to a capacitance component and a Debye empirical parameter are set. Thus, each of CPEs Q1, Q2, and Q4 is a circuit parameter including a corresponding capacitance component among the capacitance components that may be present in the electrolysis unit 2.

The capacitance component of CPE Q1 (first capacitance component) has a dominant influence on the impedance of the electrolysis unit 2 in the frequency range (first frequency range) ΔF1, and appears in the frequency range ΔF1 in the frequency characteristic of the impedance of the electrolysis unit 2. The capacitance component of CPE Q1 corresponds to a capacitance component corresponding to the resistance component (first resistance component) R1, and is included together with the resistance component R1 in an impedance component appearing in the frequency range ΔF1 in the frequency characteristic of the impedance of the electrolysis unit 2. The capacitance component of CPE Q1 corresponds to, for example, a capacitance component included in an impedance component for activation of an electrochemical reaction by a catalyst.

The capacitance component of CPE Q2 (second capacitance component) has a dominant influence on the impedance of the electrolysis unit 2 in the frequency range (second frequency range) ΔF2, and appears in the frequency range ΔF2 in the frequency characteristic of the impedance of the electrolysis unit 2. The capacitance component of CPE Q2 corresponds to a capacitance component corresponding to the resistance component (second resistance component) R2, and is included together with the resistance component R2 in an impedance component appearing in the frequency range ΔF2 in the frequency characteristic of the impedance of the electrolysis unit 2. The capacitance component of CPE Q2 corresponds to, for example, a capacitance component included in an impedance component to diffusion of substances and gases.

The capacitance component (third capacitance component) of CPE Q4 has a dominant influence on the impedance of the electrolysis unit 2 in the frequency range (fourth frequency range) ΔF4, and appears in the frequency range ΔF4 in the frequency characteristic of the impedance of the electrolysis unit 2. The capacitance component of CPE Q4 corresponds to a capacitance component corresponding to the resistance component (fourth resistance component) R4, and is included together with the resistance component R4 in the impedance component appearing in the frequency range ΔF4 in the frequency characteristic of the impedance of the electrolysis unit 2. The capacitance component of CPE Q4 corresponds to, for example, a capacitance component included in an impedance component to diffusion of ions.

In the equivalent circuit of the example of FIG. 3, a parallel connection portion of the resistance component R1 and CPE Q1, a parallel connection portion of the resistance component R2 and CPE Q2, and a parallel connection portion of the resistance component R4 and CPE Q4 are formed, and three parallel connection portions of a resistance component and a capacitance component corresponding to the resistance component are formed. Each of the three parallel connection portions corresponds to a corresponding one of the impedance components of the electrolysis unit 2. A parallel connection portion of the resistance component R1 and CPE Q1 corresponds to an impedance component that becomes dominant in the frequency range ΔF1 that is a medium frequency region, a parallel connection portion of the resistance component R2 and CPE Q2 corresponds to an impedance component that becomes dominant in the frequency range ΔF2 that is a low frequency region, and a parallel connection portion of the resistance component R4 and CPE Q4 corresponds to an impedance component that becomes dominant in the frequency range ΔF4 that is a high frequency region. In the equivalent circuit of the example of FIG. 3, the resistance component R3 and the above-described three parallel connection portions are connected in series. As described above, the resistance component R3 corresponds to the resistance component (impedance component) that becomes dominant in the frequency range ΔF3 that is the ultra-high frequency region.

In one example, in the equivalent circuit, the capacitances C1, C2, and C4 are set as circuit parameters instead of the CPEs Q1, Q2, and Q4 in the example of FIG. 3. A capacitance C1 that is a capacitance component (first capacitance component) corresponds to a capacitance component corresponding to the resistance component (first resistance component) R1, a capacitance C2 that is a capacitance component (second capacitance component) corresponds to a capacitance component corresponding to the resistance component (second resistance component) R2, and a capacitance C4 that is a capacitance component (third capacitance component) corresponds to a capacitance component corresponding to the resistance component (fourth resistance component) R4. In this example, in the equivalent circuit, a parallel connection portion of the resistance component R1 and the capacitance C1, a parallel connection portion of the resistance component R2 and the capacitance C2, and a parallel connection portion of the resistance component R4 and the capacitance C4 are formed, and three parallel connection portions of the resistance component and the capacitance component corresponding to the resistance component are formed. In the equivalent circuit, the resistance component R3 and the above-described three parallel connection portions are connected in series.

In the equivalent circuit model used for calculating the resistance values of the plurality of resistance components of the electrolysis unit 2, the relationship between the circuit parameter set in the equivalent circuit and the impedance of the electrolysis unit 2 is shown, and for example, a relational expression or the like for calculating the impedance of the electrolysis unit 2 using the circuit parameter and the frequency is shown. In the estimation of the resistance component of the electrolysis unit 2 including the resistance components R1 and R2 and the like, the processing circuit 31 and the like perform fitting calculation using, for example, the relationship between the circuit parameter and the impedance shown by the equivalent circuit model and the measurement result of the frequency characteristic of the impedance of the electrolysis unit 2.

In fitting calculation using an equivalent circuit model, calculation is performed using a circuit parameter set in an equivalent circuit including a plurality of resistance components for calculating a resistance value as a variable, and a circuit parameter to be a variable is calculated. In addition, in the fitting calculation, the value of the circuit parameter to be a variable is calculated in a state in which the difference between the calculated value of the impedance calculated using the relationship shown by the equivalent circuit model and the measured value of the impedance, which is the measurement result, is as small as possible at each of the plurality of frequencies at which the impedance is measured. By calculating circuit parameters by fitting calculation, resistance values of the resistance components R1 and R2 are calculated as a plurality of resistance components of the electrolysis unit 2. In addition, the resistance value of each of the resistance components R1 to R4 set as the circuit parameters of the equivalent circuit is calculated by performing fitting calculation using the equivalent circuit of the example of FIG. 3.

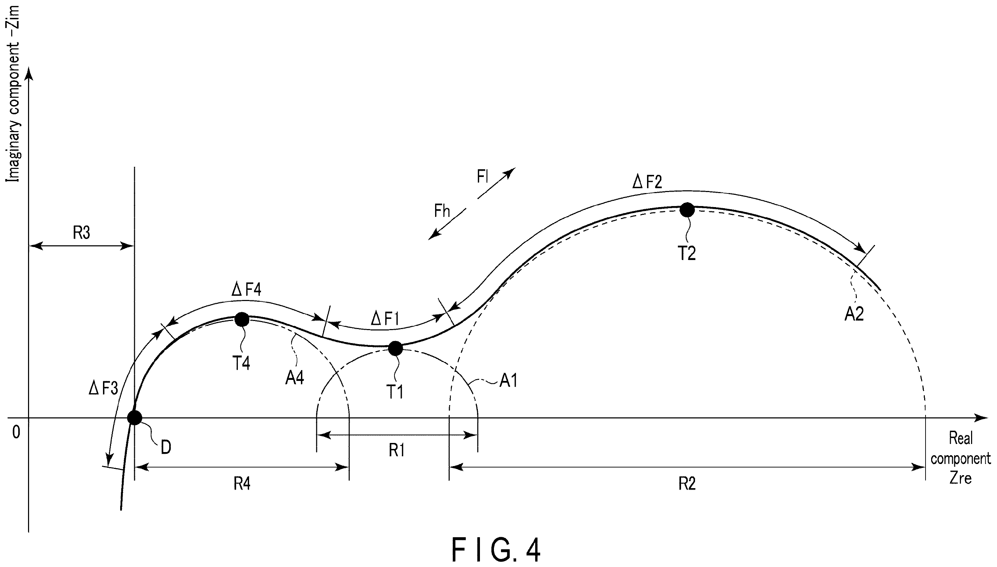

FIG. 4 is a schematic diagram illustrating an example of processing of estimating a plurality of resistance components of the electrolysis unit 2 performed by the processing circuit 31 and the like in the first approach. FIG. 4 illustrates a graph in which the abscissa axis represents the real component Zre of the impedance and the ordinate axis represents the imaginary component -Zim of the impedance. Therefore, in FIG. 4, the measurement result of the frequency characteristic of the impedance of the electrolysis unit 2 is shown by a complex impedance plot (Nyquist). In FIG. 4, an example of a complex impedance plot of the electrolysis unit 2 is shown by a solid line. In the complex impedance plot, the arrow Fh side corresponds to a high frequency side, and the arrow Fl side corresponds to a low frequency side. The complex impedance plot of the example of FIG. 4 shows a frequency range corresponding to the frequency ranges ΔF1 to ΔF4.

In the complex impedance plot of the example of FIG. 4, there is an intersection point D intersecting the abscissa axis, which is the axis of the real component, in the frequency range ΔF3 corresponding to the ultra-high frequency region. That is, in the complex impedance plot, the axis of the real component intersects at any frequency in the frequency range (third frequency range) ΔF3. The intersection frequency, which is the frequency at the intersection point D, exists in a frequency range ΔF3 in which the influence of the resistance component R3 on the impedance of the electrolysis unit 2 becomes dominant. In the example of FIG. 4, the value (positive value) of the real component of the impedance at the intersection point D of the complex impedance plot is calculated as the resistance value of the resistance component (third resistance component) R3 by performing the fitting calculation using the equivalent circuit model as described above.

In the example of FIG. 4, by performing the fitting calculation using the equivalent circuit model as described above, the impedance component including the resistance component R1, the impedance component including the resistance component R2, and the impedance component including the resistance component R4 are separated from the complex impedance plot of the electrolysis unit 2. As a result, the complex impedance plot is separated into three arc portions A1, A2, and A4. The separated three arc portions A1, A2, and A4 appear on the lower frequency side with respect to the intersection point D, and appear in the order of the arc portions A2, A1, and A4 from the lower frequency side. The arc portion A1 indicates, for example, an impedance component including a resistance component (first resistance component) R1 and a capacitance component of CPE Q1, and indicates an impedance component for activation of an electrochemical reaction by the catalyst. The arc portion A2 indicates, for example, an impedance component including a resistance component (second resistance component) R2 and a capacitance component of CPE Q2, and indicates an impedance component to diffusion of substances and gases. The arc portion A4 indicates, for example, an impedance component including the resistance component (fourth resistance component) R4 and the capacitance component of CPE Q4, and indicates an impedance component to diffusion of ions. In FIG. 4, the arc portion A1 is indicated by a one-dot chain line, the arc portion A2 is indicated by a broken line, and the arc portion A4 is indicated by a two-dot chain line.

Each of the arc portions A1, A2, and A4 has a convex shape toward the negative side of the imaginary component of the impedance. The arc portions A1, A2, and A4 have vertexes T1, T2, and T4 as vertexes of the convex shape toward the negative side of the imaginary component, respectively. At each of the vertexes T1, T2, and T4, the imaginary component of the impedance has a negative value. The vertex T1 of the arc portion A1 exists in the frequency range (first frequency range) ΔF1 corresponding to the medium frequency region. A vertex frequency (first vertex frequency) which is a frequency at the vertex T1 exists in the frequency range ΔF1 in which the influence of the impedance component including the resistance component R1 on the impedance of the electrolysis unit 2 becomes dominant. In the example of FIG. 4, the diameter of the arc portion A1 is calculated as the resistance value of the resistance component (first resistance component) R1 by performing fitting calculation using the equivalent circuit model as described above.

In addition, the vertex T2 of the arc portion A2 exists in the frequency range (second frequency range) ΔF2 corresponding to the low frequency region. A vertex frequency (second vertex frequency) which is a frequency at the vertex T2 exists in the frequency range ΔF2 in which the influence of the impedance component including the resistance component R2 on the impedance of electrolysis unit 2 becomes dominant. In the example of FIG. 4, the diameter of the arc portion A2 is calculated as the resistance value of the resistance component (second resistance component) R2 by performing fitting calculation using the equivalent circuit model as described above. In addition, the vertex T4 of the arc portion A4 exists in the frequency range (fourth frequency range) ΔF4 corresponding to the high frequency region. A vertex frequency (third vertex frequency), which is a frequency at the vertex T4, exists in the frequency range ΔF4 in which the influence of the impedance component including the resistance component R4 on the impedance of the electrolysis unit 2 becomes dominant. In the example of FIG. 4, the diameter of the arc portion A4 is calculated as the resistance value of the resistance component (fourth resistance component) R4 by performing the fitting calculation using the equivalent circuit model as described above.

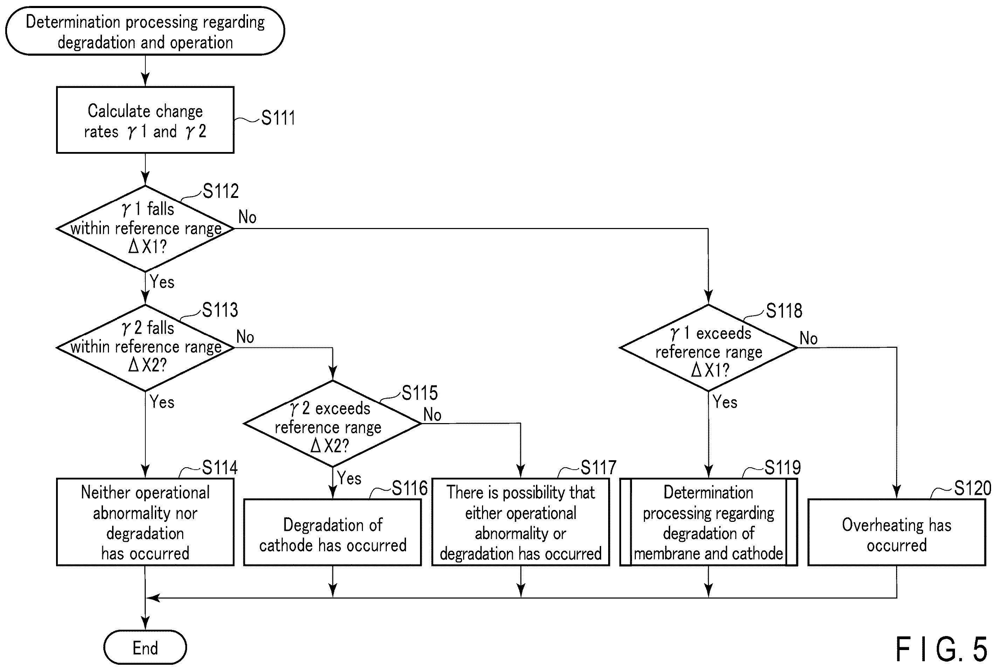

FIG. 5 is a flowchart schematically illustrating an example of determination processing regarding degradation and operation of the electrolysis unit 2 performed by the processing circuit 31 and the like in the first approach. The determination processing in the example of FIG. 5 is performed after the above-described estimation processing for the resistance component of the electrolysis unit 2 is performed in each diagnosis processing for the electrolysis unit 2 repeatedly performed over time. The determination processing in the example of FIG. 5 is performed based on the estimation results (calculation results) of the resistance components R1 and R2 of the electrolysis unit 2 in the resistance component estimation processing.

When the determination processing of the example of FIG. 5 is started, the processing circuit 31 and the like calculate change rates γ1 and γ2 with respect to the reference time as parameters indicating changes with respect to the reference time for the resistance components R1 and R2 of the electrolysis unit 2, respectively (S111). Each of the change rates γ1 and γ2, which are parameters indicating a change with respect to the reference time, is calculated as a determination parameter in the determination processing. Here, the reference time is a predetermined time point before a time point at which the impedance of the electrolysis unit 2 is measured in real time, and corresponds to, for example, a start time point of operation of the electrolysis unit 2. The change rate γ1 of the resistance component (first resistance component) R1 becomes (R1(t)-R1(0))/R1(0) using the resistance value R1(0) at the reference time (time t=0) and the resistance value R1(t) calculated in real time. Similarly, the change rate γ2 of the resistance component (second resistance component) R2 is (R2(t)-R2(0))/R2(0) using the resistance value R2(0) at the reference time and the resistance value R2(t) calculated in real time. In a case where the reference time corresponds to the start time point of operation of the electrolysis unit 2, the resistance value R1(0) at the reference time is set as the initial value of the resistance component R1, and R2(0) is set as the initial value of the resistance component R2.

Since the change rates γ1 and γ2 are defined as described above, the change rate γ1 is defined as a determination parameter (first determination parameter) indicating a change in the resistance component R1 with respect to the reference time, and the change rate γ2 is defined as a determination parameter (second determination parameter) indicating a change in the resistance component R2 with respect to the reference time. In a case where the resistance component R1 is unchanged with respect to the reference time, the change rate (first change rate) γ1 is 0, and in a case where the resistance component R2 is unchanged with respect to the reference time, the change rate (second change rate) γ2 is 0. In a case where the resistance component R1 increases with respect to the reference time, the change rate γ1 is a positive value (a value larger than 0), and in a case where the resistance component R1 decreases with respect to the reference time, the change rate γ1 is a negative value (a value smaller than 0). Similarly, in a case where the resistance component R2 increases with respect to the reference time, the change rate γ2 is a positive value (a value larger than 0), and in a case where the resistance component R2 decreases with respect to the reference time, the change rate γ2 is a negative value (a value smaller than 0). Then, when each of the change rates γ1 and γ2 is calculated, the processing circuit 31 and the like perform the processing after S112 using the change rates γ1 and γ2 calculated as the determination parameters.

In the determination processing of the example of FIG. 5, reference ranges ΔX1 and ΔX2 are defined for the change rates γ1 and γ2, respectively. The reference range (first reference range) ΔX1 of the change rate γ1 includes a value in a case where the resistance component R1 is unchanged with respect to the reference time. Similarly, the reference range (second reference range) ΔX2 of the change rate γ2 includes a value in a case where the resistance component R2 is unchanged with respect to the reference time. Therefore, the value 0 is included in the reference range ΔX1 of the change rate γ1 of the lower limit value γ1low or more and the upper limit value γ1up or less, and the value 0 is included in the reference range ΔX2 of the change rate γ2 of the lower limit value γ2low or more and the upper limit value γ2up or less. In one example, the range of ±Δγ1 with the value 0 as the median value is the reference range ΔX1 of the change rate γ1, and -Δγ1 and Δγ1 are the lower limit value γ1low and the upper limit value γ1up of the reference range ΔX1 of the change rate γ1, respectively. The range of ±Δγ2 with the value 0 as the median value is the reference range ΔX2 of the change rate γ2, and -Δγ2 and Δγ2 are the lower limit value γ2low and the upper limit value γ2up of the reference range ΔX2 of the change rate γ2, respectively. In this case, each of ±Δγ1 and ±Δγ2 is, for example, ±10%. Preferably, each of ±Δγ1 and ±Δγ2 is ±2%.

In the determination processing of the example of FIG. 5, when each of the change rates γ1 and γ2 is calculated as the determination parameter, the processing circuit 31 and the like compare the calculation result by the processing of S111 with the reference range ΔX1 set as described above for the change rate γ1. That is, the processing circuit 31 and the like compare the calculation result of the determination parameter (first determination parameter), which is a parameter indicating the change in the resistance component R1 with respect to the reference time, with the reference range (first reference range) ΔX1. Then, the processing circuit 31 and the like determine whether or not the change rate γ1 of the resistance component (first resistance component) R1 falls within the reference range ΔX1 of the lower limit value γ1low or more and the upper limit value γ1up or less (S112). In a case where the change rate γ1, which is the determination parameter (first determination parameter), falls within the reference range ΔX1 (S112-Yes), the processing circuit 31 and the like compare the calculation result by the processing of S111 with the reference range ΔX2 set as described above for the change rate γ2. That is, the processing circuit 31 and the like compare the calculation result of the determination parameter (second determination parameter), which is a parameter indicating the change in the resistance component R2 with respect to the reference time, with the reference range (second reference range) ΔX2. Then, the processing circuit 31 and the like determine whether or not the change rate γ2 of the resistance component (second resistance component) R2 falls within the reference range ΔX2 of the lower limit value γ2low or more and the upper limit value γ2up or less (S113).

In a case where the change rate γ2 as the determination parameter falls within the reference range ΔX2 (S113-Yes), the processing circuit 31 and the like determine that neither the operational abnormality nor the degradation has occurred in the electrolysis unit 2 (S114). Therefore, based at least on the fact that the change rate γ1 of the resistance component R1 falls within the reference range ΔX1 and the change rate γ2 of the resistance component R2 falls within the reference range ΔX2, it is determined that neither the operational abnormality nor the degradation has occurred. In a case where the change rate γ2 does not fall within the reference range ΔX2 (S113-No), the processing circuit 31 and the like determine whether or not the change rate γ2 exceeds the reference range ΔX2 (S115). At this time, the processing circuit 31 and the like determine whether the change rate γ2 is larger than the upper limit value γ2up of the reference range ΔX2 or the change rate γ2 is smaller than the lower limit value γ2low of the reference range ΔX2.

In a case where the change rate γ2 exceeds (is more than) the reference range ΔX2 (S115-Yes), the processing circuit 31 and the like determine that degradation of the cathode has occurred in the electrolysis unit 2 (S116). Therefore, based on the fact that the change rate γ1 of the resistance component R1, which is the determination parameter (first determination parameter), falls within the reference range ΔX1 and the change rate γ2 of the resistance component R2, which is the determination parameter (second determination parameter), exceeds the reference range ΔX2, it is determined that degradation of the cathode has occurred in the electrolysis unit 2. At this time, it is determined that the membrane is not deteriorated. On the other hand, in a case where the change rate γ2 is below the reference range ΔX2 (S115-No), the processing circuit 31 and the like determine that there is a possibility that either operational abnormality or degradation has occurred in the electrolysis unit 2 (S117). In this case, for example, based on the calculation results of the resistance values of the resistance components R3 and R4, a further determination may be made on the degradation and operation of the electrolysis unit.

In a case where the change rate γ1 does not fall within the reference range ΔX1 in S112 (S112-No), the processing circuit 31 and the like determine whether or not the change rate γ1 exceeds (is more than) the reference range ΔX1 (S118). At this time, the processing circuit 31 and the like determine whether the change rate γ1 is larger than the upper limit value γ1up of the reference range ΔX1 or the change rate γ1 is smaller than the lower limit value γ1low of the reference range ΔX1. In a case where the change rate γ1 exceeds the reference range ΔX1 (S118-Yes), the processing circuit 31 and the like perform determination processing regarding degradation of the membrane and the cathode (S119). On the other hand, in a case where the change rate γ1 is below the reference range ΔX1 (S118-No), the processing circuit 31 and the like determine that the overheating has occurred in the electrolysis unit 2 (S120). Therefore, based on the fact that the change rate γ1 of the resistance component R1, which is the determination parameter (first determination parameter), is below the reference range ΔX1, it is determined that the overheating has occurred in the electrolysis unit 2 as the operational abnormality.

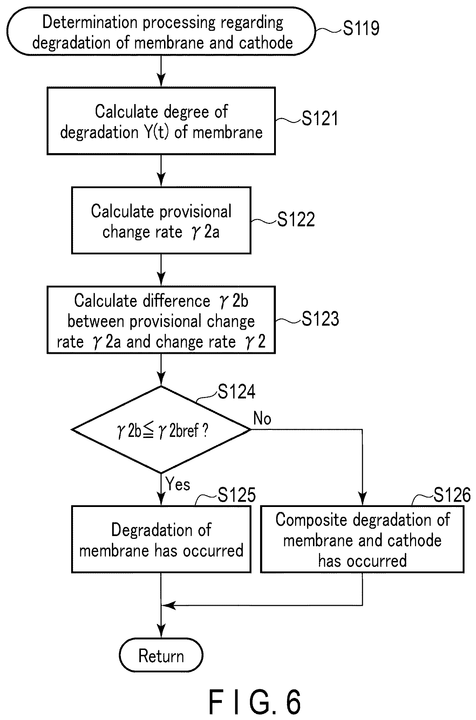

FIG. 6 is a flowchart schematically illustrating an example of determination processing (S119) regarding degradation of the membrane and the cathode performed by the processing circuit 31 and the like in the determination processing of the example of FIG. 5. The determination processing of the example of FIG. 6 is performed in a case where the change rate γ1 of the resistance component R1 exceeds the reference range ΔX1 in the determination processing of the example of FIG. 5. In the determination processing in the example of FIG. 6, a degree of degradation Y of the membrane in the electrolysis unit 2 is defined as a parameter. When the determination processing of the example of FIG. 6 is started, the processing circuit 31 and the like calculate a degree of degradation Y(t) of the membrane in real time for the degree of degradation Y of the membrane based on the resistance value R1(t) of the resistance component (first resistance component) R1 in real time (S121). The storage medium 32 stores relational data indicating the relationship between the resistance component R1 and the degree of degradation Y of the membrane. The processing circuit 31 and the like calculate the degree of degradation Y(t) of the membrane in real time using the resistance value R1(t) of the resistance component (first resistance component) R1 in real time and the relational data indicating the relationship between the resistance component R1 and the degree of degradation Y of the membrane.

Then, based on the calculation result of the degree of degradation Y(t) of the membrane in real time, the processing circuit and the like 31 calculate a provisional change rate γ2a of the resistance component (second resistance component) R2 of the electrolysis unit 2 as a change rate with respect to the reference time in a case where it is assumed that only degradation of the membrane has occurred in the electrolysis unit 2 (S122). The provisional change rate γ2a corresponds to a change rate of the resistance component R2 with respect to the reference time in a case where it is assumed that degradation of the cathode has not occurred in the electrolysis unit 2. In addition, the provisional change rate γ2a is a parameter indicating a change caused by the degradation of the membrane in the change of the resistance component R2 with respect to the reference time, and is calculated as a determination parameter (third determination parameter) in the determination processing. Here, for the resistance component R2, a provisional resistance value R2a is defined as a resistance value in a case where it is assumed that only degradation of the membrane has occurred in the electrolysis unit 2. The storage medium 32 stores relational data indicating the relationship between the degree of degradation Y of the membrane and the provisional resistance value R2a of the resistance component R2. The processing circuit 31 and the like calculate the provisional resistance value R2a and the provisional change rate γ2a of the resistance component R2 using the degree of degradation Y(t) of the membrane in real time and the relational data indicating the relationship between the degree of degradation Y of the membrane and the provisional resistance value R2a of the resistance component R2.

Then, the processing circuit 31 and the like compare the calculation result of the change rate γ2 with the calculation result of the provisional change rate γ2a for the resistance component R2. That is, the processing circuit 31 and the like compare the calculation result of the determination parameter (second determination parameter) indicating the change in the resistance component R2 with respect to the reference time with the calculation result of the determination parameter (third determination parameter) indicating the change caused by the degradation of the membrane among the changes in the resistance component R2 with respect to the reference time. Then, the processing circuit 31 and the like calculate a difference γ2b between the provisional change rate γ2a and the change rate γ2 for the resistance component R2 (S123). At this time, for example, an absolute value of a subtraction value obtained by subtracting the provisional change rate γ2a from the change rate γ2 is calculated as the difference γ2b. Therefore, in a case where the change rate γ2 matches the provisional change rate γ2a, the difference γ2b becomes zero. By calculating the difference γ2b, the change caused by the degradation of the membrane is removed in the change in the resistance component R2 with respect to the reference time. In addition, the difference γ2b is calculated as a parameter indicating a change caused by the degradation of the cathode in the change of the resistance component R2 with respect to the reference time. Therefore, by calculating the provisional change rate γ2a and the difference γ2b, the change in the resistance component R2 with respect to the reference time can be divided into a change caused by the degradation of the membrane and a change caused by the degradation of the cathode.

In the determination processing of the example of FIG. 6, a reference value γ2bref is defined in regard to the difference γ2b of the provisional change rate γ2a with respect to the change rate γ2. The reference value γ2bref is set to, for example, a value of 10% of the change rate γ2. Preferably, the reference value γ2bref is set to a value of 2% of the change rate γ2. Then, the processing circuit 31 and the like determine whether or not the difference γ2b between the provisional change rate γ2a and the change rate γ2 is equal to or less than the reference value γ2bref (S124). In a case where the difference γ2b is less than or equal to the reference value γ2bref (S124-Yes), the processing circuit 31 and the like determine that degradation of the membrane has occurred in the electrolysis unit 2 (S125). Therefore, based at least on the fact that the change rate γ1 of the resistance component R1 exceeds the reference range ΔX1 and the difference γ2b between the provisional change rate γ2a and the change rate γ2 for the resistance component R2 is equal to or less than the reference value γ2bref, it is determined that degradation of the membrane has occurred. At this time, it is determined that degradation of the cathode has not occurred.

On the other hand, in a case where the difference γ2b is larger than the reference value γ2bref (S124-No), the processing circuit 31 and the like determine that composite degradation of the membrane and the cathode has occurred in the electrolysis unit 2 (S126). Therefore, based at least on the fact that the change rate γ1 of the resistance component R1 exceeds the reference range ΔX1 and the difference γ2b between the provisional change rate γ2a and the change rate γ2 for the resistance component R2 is larger than the reference value γ2bref, it is determined that composite degradation of the membrane and the cathode has occurred. The composite degradation of the membrane and the cathode corresponds to occurrence of degradation in both the membrane and the cathode.

By performing the determination processing in the example of FIG. 5, the processing circuit 31 and the like compare the calculation result in the real-time diagnosis with the reference range ΔX1 including the value in a case where the resistance component R1 is unchanged with respect to the reference time for the change rate γ1 of the resistance component R1 of the electrolysis unit 2, thereby determining regarding the degradation and the operation of the electrolysis unit 2. In the determination processing of the example of FIG. 5, in the determination regarding the degradation and the operation of the electrolysis unit 2, the calculation result in the real-time diagnosis is compared with the reference range ΔX2 including the value in a case where the resistance component R2 is unchanged with respect to the reference time for the change rate γ2 of the resistance component R2 of the electrolysis unit 2. In addition, in the determination processing of the example of FIG. 6, the provisional change rate γ2a is calculated as a parameter indicating a change caused by the degradation of the membrane in the change of the resistance component R2 with respect to the reference time based on the calculation result of the resistance value of the resistance component R1 in the real-time diagnosis. Then, for the resistance component R2, the calculation result of the change rate γ2 in the real-time diagnosis is compared with the calculation result of the provisional change rate γ2a in the real-time diagnosis, thereby determining regarding the degradation and the operation of the electrolysis unit 2. Therefore, by performing the determination processing of the example of FIG. 5 and the example of FIG. 6, the processing circuit 31 and the like determine regarding the degradation and the operation of the electrolysis unit 2 based at least on the calculation results of the resistance values of the resistance components R1 and R2.

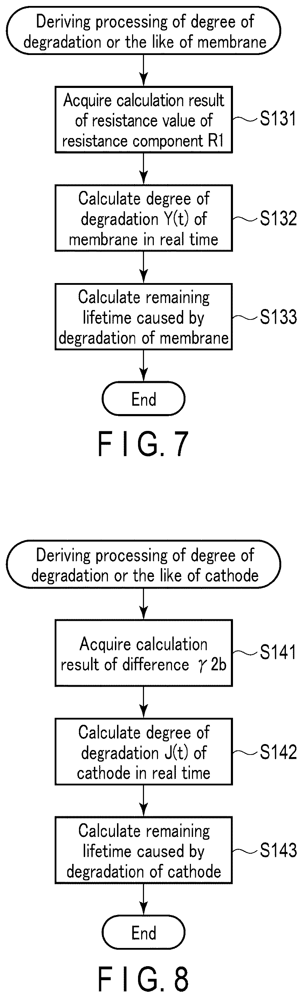

Further, in one example of the approach and the like, in a case where it is determined that the change rate γ1 of the resistance component R1 exceeds the reference range ΔX1, the processing circuit 31 and the like derive the degree of degradation and the like of the membrane of the electrolysis unit 2. FIG. 7 is a flowchart schematically illustrating an example of deriving processing of deriving a degree of degradation or the like of the membrane of the electrolysis unit 2 performed by the processing circuit 31 and the like in the first approach. The deriving processing of the example of FIG. 7 is performed in a case where it is determined that the change rate γ1 exceeds the reference range ΔX1 in the determination processing of the example of FIG. 5 or the like, and is performed in a case where the determination processing regarding the degradation of the membrane and the cathode of the example of FIG. 6 or the like is performed. That is, in each of the case in which it is determined that only the degradation of the membrane has occurred and the case where it is determined that the composite degradation of the membrane and the cathode has occurred, the deriving processing of the example of FIG. 7 is performed. When the deriving processing of the example of FIG. 7 is started, the processing circuit 31 and the like acquire a real-time calculation result of the resistance value of the resistance component (first resistance component) R1 (S131). At this time, the processing circuit 31 and the like may acquire the calculation result of the change rate γ1 of the resistance component R1 with respect to the reference time, which is the determination parameter (first determination parameter), in addition to the resistance value of the resistance component R1. The resistance value of the resistance component R1 and the change rate γ1 are calculated by the above-described calculation or the like.

Then, the processing circuit 31 and the like calculate the degree of degradation Y(t) of the membrane in real time based at least on the calculation result of the resistance value of the resistance component R1 (S132). At this time, the degree of degradation Y(t) of the membrane in real time is calculated using the calculation result of the resistance value of the resistance component R1, relational data indicating the relationship between the resistance component R1 and the degree of degradation Y of the membrane stored in the storage medium 32 or the like, and the like. In this example, a limit resistance value R1ter corresponding to the operation limit of the electrolysis unit 2 is set for the resistance value of the resistance component R1. The limit resistance value Rlter is set to a value higher than the resistance value R1(0) at the reference time. In the relational data indicating the relationship between the resistance component R1 and the degree of degradation Y of the membrane, for example, in a case where the resistance value of the resistance component R1 is the limit resistance value R1ter, the degree of degradation of the membrane is 100%. In the processing of S132, the degree of degradation Y(t) of the membrane in real time is calculated by, for example, comparing the amount of increase in the resistance value R1(t) in real time from the resistance value R1(0) at the reference time with the difference between the resistance value R1(0) of the resistance component R1 at the reference time (t=0) such as the start time point of operation of the electrolysis unit 2 and the limit resistance value R1ter.

Then, the processing circuit 31 and the like derive the remaining lifetime of the electrolysis unit 2 caused by the degradation of the membrane based on the calculation result of the resistance value of the resistance component R1 and the deriving result of the degree of degradation Y(t) of the membrane in real time (S133). At this time, the processing circuit 31 and the like calculate, for example, a net operating time of the electrolysis unit 2 from a reference time such as a start time point of operation to a time point at which the resistance component R1 becomes the resistance value R1(t). Then, the processing circuit 31 and the like calculate the remaining time from the present time point until the resistance component R1 reaches the limit resistance value Rlter based on the degree of degradation Y(t) of the membrane in real time and the net operating time. Then, the calculated remaining time is derived as the remaining lifetime of the electrolysis unit 2 caused by the degradation of the membrane.

In one example of the approach and the like, in a case where it is determined that the composite degradation of the membrane and the cathode has occurred in the electrolysis unit 2, the processing circuit 31 and the like derive the degree of degradation of the cathode of the electrolysis unit 2 and the like. FIG. 8 is a flowchart schematically illustrating an example of deriving processing of deriving a degree of degradation or the like of the cathode of the electrolysis unit 2 performed by the processing circuit 31 and the like in the first approach. In the deriving processing in the example of FIG. 8, the degree of degradation J of the cathode in the electrolysis unit 2 is defined as a parameter. The deriving processing of the example of FIG. 8 is performed in a case where it is determined that composite degradation of the membrane and the cathode has occurred in the determination processing of the example of FIG. 6 and the like. When the deriving processing of the example of FIG. 8 is started, the processing circuit 31 and the like acquire a real-time calculation result of the difference γ2b between the provisional change rate γ2a and the change rate γ2 for the resistance component (second resistance component) R2 (S141). At this time, in addition to the difference γ2b, the processing circuit 31 and the like may acquire calculation results of the change rate γ2, which is a determination parameter (second determination parameter), the provisional change rate γ2a, which is a determination parameter (third determination parameter), and the like. The resistance value, the change rate γ2, the provisional change rate γ2a, and the difference γ2b of the resistance component R2 are calculated by the above-described calculation or the like.

Then, the processing circuit 31 and the like calculate the degree of degradation J(t) of the cathode in real time based at least on the calculation result of the difference γ2b (S142). The storage medium 32 stores relational data indicating the relationship between the difference γ2b and the degree of degradation J of the cathode. The processing circuit 31 and the like calculate the degree of degradation J(t) of the cathode in real time using the calculation result of the difference γ2b between the provisional change rate γ2a and the change rate γ2, relational data indicating the relationship between the difference γ2b and the degree of degradation J of the cathode stored in the storage medium 32 or the like, and the like. Here, at the reference time (t=0), the difference γ2b(0) is zero. In this example, a limit value γ2bter corresponding to the operation limit of the electrolysis unit 2 is set for a difference γ2b between the provisional change rate γ2a and the change rate γ2. In the relational data indicating the relationship between the difference γ2b and the degree of degradation J of the cathode, for example, in a case where the difference γ2b is the limit value γ2bter, the degree of degradation of the cathode is 100%. In the processing of S142, the degree of degradation J(t) of the cathode in real time is calculated by comparing the value γ2b(t) of the difference γ2b in real time with the limit value γ2bter of the difference γ2b.

Then, the processing circuit 31 and the like derive the remaining lifetime of the electrolysis unit 2 caused by the degradation of the cathode based on the calculation result of the difference γ2b and the deriving result of the degree of degradation J(t) of the cathode in real time (S143). At this time, the processing circuit 31 and the like calculate a net operating time of the electrolysis unit 2 from a reference time such as a start time point of operation to a time point at which the difference γ2b becomes the value γ2b(t). Then, the processing circuit 31 and the like calculate the remaining time from the present time point until the difference γ2b reaches the limit value γ2bter based on the degree of degradation J(t) of the cathode in real time and the net operating time. Then, the calculated remaining time is derived as the remaining lifetime of the electrolysis unit 2 caused by the degradation of the cathode.

Here, in the electrolysis unit 2, when overheating occurs, the electrochemical reaction is easily activated by the catalyst, and substances, ions, and the like are easily diffused. Therefore, when the overheating occurs, each of the plurality of resistance components of the electrolysis unit 2 including the resistance components R1 and R2 decreases with respect to the reference time when the overheating does not occur. In the present approach, as in the example of FIG. 5 and the like, it is determined that overheating has occurred in the electrolysis unit 2 based on the fact that the change rate γ1 of the resistance component R1 is below the reference range ΔX1. By performing such determination, occurrence of overheating is appropriately determined and grasped in the electrolysis unit 2.

In the electrolysis unit 2, when degradation of the membrane occurs, at least one of an increase in porosity of the membrane and thinning of the membrane occurs. For this reason, when the degradation of the membrane occurs, the substance or the like easily diffuses in the electrolysis unit 2, and the resistance component R2, which is a resistance component to the diffusion of the substance and the gas, tends to decrease caused by the degradation of the membrane. On the other hand, when the membrane is thinned caused by the occurrence of degradation of the membrane, the catalyst hardly acts on the electrochemical reaction of the feedstock such as carbon dioxide, and the electrochemical reaction is hardly activated by the catalyst. Therefore, when degradation of the membrane occurs, the resistance component R1, which is a resistance component to the activation of the electrochemical reaction by the catalyst, tends to increase caused by the degradation of the membrane.

In addition, in the electrolysis unit 2, examples of the cause of degradation of the cathode include precipitation of salt on the surface of the catalyst layer, flooding in which the catalyst layer is filled with an electrolysis solution, and degradation of the catalyst. When either precipitation of salt or flooding occurs, it becomes difficult for a feedstock such as carbon dioxide to be supplied to the cathode, and it becomes difficult for a substance or the like to diffuse. In addition, even if degradation of the catalyst occurs in the cathode, the substance or the like hardly diffuses. Therefore, the resistance component R2, which is a resistance component to diffusion of substances and gases, tends to increase caused by degradation of the cathode. In addition, even if degradation of the cathode occurs, resistance components other than the resistance component R2 such as the resistance component R1 tend not to change or hardly change.

In a case where the composite degradation of the membrane and the cathode has occurred in the electrolysis unit 2, the degradation of the cathode hardly affects the resistance component R1. Therefore, as in the case where only the membrane is deteriorated, the resistance component R1 tends to increase. On the other hand, in a case where the composite degradation of the membrane and the cathode has occurred in the electrolysis unit 2, the resistance component R2 is affected by both the degradation of the membrane and the degradation of the cathode. Therefore, the resistance component R2 changes by a change amount corresponding to both the increase amount caused by the degradation of the membrane and the decrease amount caused by the degradation of the cathode with respect to the reference time.

In the present approach, as in the example of FIG. 5 and the like, based on the fact that the change rate γ1 of the resistance component R1 falls within the reference range ΔX1 and the change rate γ2 of the resistance component R2 exceeds the reference range ΔX2, it is determined that degradation of the cathode has occurred in the electrolysis unit 2. By performing such a determination, in the electrolysis unit 2, the occurrence of the degradation of the cathode is appropriately determined and grasped, and the state in which the degradation of the cathode occurs is appropriately grasped although the degradation of the membrane has not occurred. In the present approach, as in the example of FIGS. 5 and 6, in a case where the change rate γ1 of the resistance component R1 exceeds the reference range ΔX1, it is determined that at least degradation of the membrane has occurred in the electrolysis unit 2. By performing such a determination, occurrence of degradation of the membrane is appropriately determined and grasped in the electrolysis unit 2.

In the present approach, as illustrated in the example of FIGS. 5 and 6, in a case where the change rate γ1 of the resistance component R1 exceeds the reference range ΔX1, a provisional change rate γ2a, which is a parameter indicating a change caused by degradation of the membrane in the change of the resistance component R2 with respect to the reference time, is calculated based on the calculation result of the resistance value of the resistance component R1. Then, based on the difference γ2b between the provisional change rate γ2a and the change rate γ2 of the resistance component R2, it is determined whether or not degradation of the cathode has occurred in addition to degradation of the membrane in the electrolysis unit 2. In the present approach, in a case where the difference γ2b is equal to or less than the reference value γ2bref, it is determined that only the degradation of the membrane has occurred in the electrolysis unit 2 and the degradation of the cathode has not occurred. In a case where the difference γ2b is larger than the reference value γ2bref, it is determined that composite degradation of the membrane and the cathode has occurred in the electrolysis unit 2. By performing such a determination, in the electrolysis unit 2, each of the state where degradation of the cathode has not occurred but degradation of the membrane has occurred, and the state where composite degradation of the cathode and the membrane has occurred is appropriately determined and grasped.

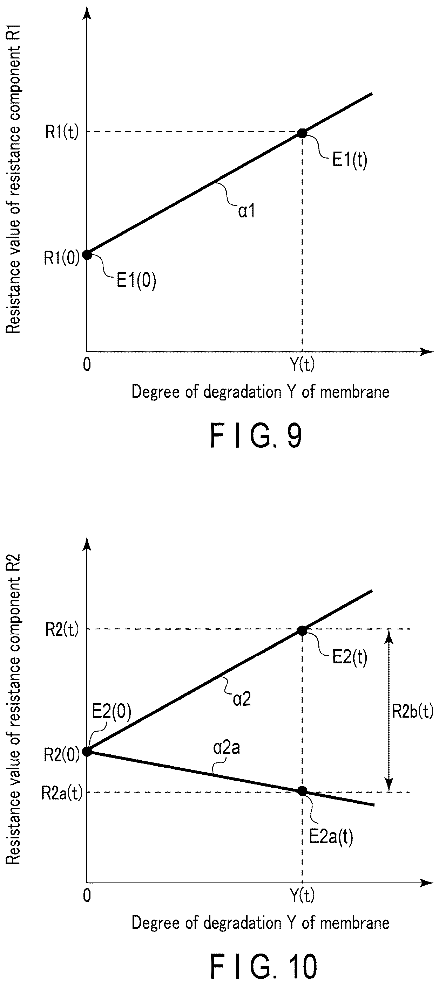

FIG. 9 is a schematic diagram for explaining an example of processing of deriving the degree of degradation Y of the membrane of the electrolysis unit 2 performed by the processing circuit 31 and the like in the first approach. In the example of FIG. 9, an example in which the electrolysis unit 2 in which the composite degradation of the membrane and the cathode occurs is a diagnosis target will be described. FIG. 9 shows a graph in which the abscissa axis represents the degree of degradation Y of the membrane and the ordinate axis represents the resistance value of the resistance component (first resistance component) R1. In the example of FIG. 9, the change rate γ1 of resistance component R1 exceeds the reference range ΔX1, and the processing circuit 31 and the like determine that at least degradation of the membrane has occurred in the electrolysis unit 2. In the example of FIG. 9, the resistance value R1(t) of the resistance component R1 in real time is calculated, and the calculation result of the resistance value R1(t) in real time is indicated by a point E1(t). The resistance value R1(0) of the resistance component R1 at the start time point of operation as the reference time (t=0) is indicated by a point E1(0).

In the example of FIG. 9, the relationship indicated by line α1 is stored in the storage medium 32 as relational data indicating the relationship between the resistance component R1 and the degree of degradation Y of the membrane. The relationship between the resistance component R1 and the degree of degradation Y of the membrane indicates the same tendency as the relationship indicated by the line α1 regardless of whether or not degradation of the cathode has occurred. In the example of FIG. 9, the degree of degradation Y(t) of the membrane in real time is calculated based on the calculation result of the resistance value R1(t) of the resistance component R1 in real time and the relationship between the resistance component R1 and the degree of degradation Y of the membrane indicated by the line α1.

FIG. 10 is a schematic diagram illustrating an example of processing of calculating a difference γ2b between a provisional change rate γ2a and a change rate γ2 for a resistance component (second resistance component) R2 of the electrolysis unit 2, the processing being performed by the processing circuit 31 and the like in the first approach. In the example of FIG. 10, an example in which the electrolysis unit 2 in which the degree of degradation Y of the membrane is calculated in the example of FIG. 9 is a diagnosis target, that is, an example in which the electrolysis unit 2 in which the composite degradation of the membrane and the cathode has occurred is a diagnosis target will be described. Therefore, in the example of FIG. 10, the change rate γ1 of the resistance component R1 exceeds the reference range ΔX1, and the processing circuit 31 and the like determine that at least degradation of the membrane has occurred in the electrolysis unit 2. FIG. 10 shows a graph in which the abscissa axis represents the degree of degradation Y of the membrane and the ordinate axis represents the resistance value of the resistance component (second resistance component) R2.

In the example of FIG. 10, the resistance value R2(t) of the resistance component R2 in real time is calculated, and the calculation result of the resistance value R2(t) in real time is indicated by a point E2(t). The resistance value R2(0) of the resistance component R2 at the start time point of operation as the reference time is indicated by a point E2(0). Here, as described above, the provisional resistance value R2a is defined as the resistance value of the resistance component R2 in a case where it is assumed that only the degradation of the membrane has occurred in the electrolysis unit 2. In the example of FIG. 10, in the storage medium 32, the relationship indicated by a line α2a is stored in the storage medium 32 as relational data indicating the relationship between the provisional resistance value R2a of the resistance component R2 and the degree of degradation Y of the membrane. In a case where degradation of the cathode does not occur and only degradation of the membrane occurs, the relationship between the resistance component R2 and the degree of degradation Y of the membrane indicates the same tendency as the relationship indicated by the line α2a.

In the example of FIG. 10, the provisional resistance value R2a(t) of the resistance component R2 in real time is calculated based on the calculated degree of degradation Y(t) of the membrane in real time and the relationship between the provisional resistance value R2a of the resistance component R2 and the degree of degradation Y of the membrane indicated by the line α2a. The calculation result of the provisional resistance value R2a(t) in real time is indicated by a point E2a(t). In the example of FIG. 10, the real-time value γ2b(t) is calculated for the difference γ2b between the provisional change rate γ2a and the change rate γ2 based on the difference R2b(t) between the provisional resistance value R2a(t) at the point E2a(t) and the resistance value R2(t) at the point E2(t). The real-time value γ2b(t) of the difference γ2b is calculated by dividing the difference R2b(t) by the resistance value R2(0) of the resistance component R2 at the reference time.

In a case where the degradation of the membrane and the cathode progresses similarly to the electrolysis unit 2 to be diagnosed in the example of FIG. 10, the relationship between the resistance component R2 and the degree of degradation Y of the membrane indicates the same tendency as the relationship indicated by the line α2. In the example of FIG. 10, the change rate γ2 is calculated by subtracting the resistance value R2(0) of the resistance component R2 at the reference time from the resistance value R2(t) at the point E2(t) and dividing the subtracted value by the resistance value R2(0). Then, the provisional change rate γ2a is calculated by subtracting the resistance value R2(0) of the resistance component R2 at the reference time from the provisional resistance value R2a(t) at the point E2a(t) and dividing the subtracted value by the resistance value R2(0).

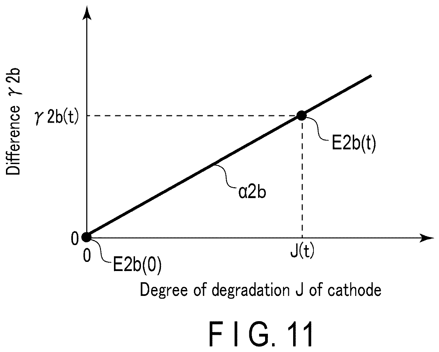

FIG. 11 is a schematic diagram illustrating an example of processing of deriving the degree of degradation J of the cathode of the electrolysis unit 2 performed by the processing circuit 31 and the like in the first approach. In the example of FIG. 11, an example in which the electrolysis unit 2 in which the difference γ2b between the provisional change rate γ2a and the change rate γ2 is calculated in the example of FIG. 10 is a diagnosis target, that is, an example in which the electrolysis unit 2 in which the composite degradation of the membrane and the cathode has occurred is a diagnosis target will be described. Therefore, in the example of FIG. 11, the difference γ2b is larger than the reference value γbref, and the processing circuit 31 and the like determine that composite degradation of the membrane and the cathode has occurred in the electrolysis unit 2. FIG. 11 shows a graph in which the abscissa axis represents the degree of degradation J of the cathode, and the ordinate axis represents the difference γ2b between the provisional change rate γ2a and the change rate γ2 of the resistance component R2.

In the example of FIG. 11, a real-time value γ2b(t) of the difference γ2b is indicated by a point E2b(t). Then, the difference γ2b at the start time point of operation as the reference time becomes zero, and is indicated by a point E2b(0) which is the origin of the graph. In the example of FIG. 11, the relationship indicated by a line α2b is stored in the storage medium 32 as relational data indicating the relationship between the difference γ2b of the provisional change rate γ2a to the change rate γ2 and the degree of degradation J of the cathode. In the example of FIG. 11, the degree of degradation J(t) of the cathode in real time is calculated based on the calculation result of the value γ2b(t) of the difference γ2b in real time and the relationship between the difference γ2b and the degree of degradation J of the cathode indicated by the line α2b.

As described above, in the present approach, by performing the determination processing of the example of FIG. 5 and the example of FIG. 6, the degradation and operation of the electrolysis unit 2 are determined based at least on the resistance component R1 in which the influence on the impedance of the electrolysis unit 2 is dominant in the frequency range ΔF1 and the resistance component R2 in which the influence on the impedance of the electrolysis unit 2 is dominant in the frequency range ΔF2. Then, by the determination processing based on the resistance components R1 and R2, the occurrence of the operational abnormality in the electrolysis unit 2 such as overheating can be appropriately grasped, and the occurrence of the degradation in the electrolysis unit 2 such as the degradation of the membrane, the degradation of the cathode, and the composite degradation of the membrane and the cathode can be appropriately grasped. Therefore, in the present approach, the degradation state and the operation status of the electrolysis unit 2 can be appropriately grasped by the determination processing based on the resistance components R1 and R2.

In the present approach, in a case where the change rate γ1 of the resistance component R1 exceeds the reference range ΔX1, the provisional change rate γ2a of the resistance component R2 is calculated as a parameter indicating a change caused by degradation of the membrane in the change of the resistance component R2 with respect to the reference time. Then, by calculating the difference γ2b between the provisional change rate γ2a and the change rate γ2 for the resistance component R2, a parameter indicating a change caused by the degradation of the cathode in the change of the resistance component R2 with respect to the reference time is calculated. Therefore, in a case where the composite degradation of the membrane and the cathode has occurred in the electrolysis unit 2, by calculating the provisional change rate γ2a and the difference γ2b as described above, the change in the resistance component R2 with respect to the reference time can be appropriately divided into the change caused by the degradation of the membrane and the change caused by the degradation of the cathode.

In a preferred example of the present approach and the like, in addition to the frequency ranges ΔF1 and ΔF2, the impedance of the electrolysis unit 2 is measured in the frequency range ΔF3 higher in the frequency than the frequency range ΔF1. In the equivalent circuit used for calculating the resistance values of the resistance components R1 and R2, a parallel connection portion corresponding to an impedance component including the resistance component R1, a parallel connection portion corresponding to an impedance component including the resistance component R2, and a parallel connection portion corresponding to an impedance component including the resistance component R4 are set, and the resistance component R3 and the three parallel connection portions are connected in series. By using such an equivalent circuit, in addition to the resistance components R1 and R2, the resistance value is calculated by fitting calculation or the like for the resistance component R3 in which the influence on the impedance of the electrolysis unit 2 becomes dominant in the frequency range ΔF3 and the resistance component R4 in which the influence on the impedance of the electrolysis unit 2 becomes dominant in the frequency range ΔF4 between the frequency ranges ΔF1 and ΔF3. As a result, the resistance value of each of the resistance components R1 to R4 is calculated to a more appropriate value. Since the determination is made based on the resistance values of the resistance components R1 and R2 calculated to appropriate values, the accuracy of the determination regarding the degradation and operation of the electrolysis unit 2 is improved.

### (Modification)

In a modification, for a resistance component (first resistance component) R1 of the electrolysis unit 2, a change amount ε1 with respect to a reference time is calculated as a parameter indicating a change with respect to the reference time, and the change amount ε1 is calculated as a determination parameter (first determination parameter) in the determination processing. Then, for a resistance component (second resistance component) R2 of the electrolysis unit 2, a change amount ε2 with respect to a reference time is calculated as a parameter indicating a change with respect to the reference time, and the change amount ε2 is calculated as a determination parameter (second determination parameter) in the determination processing. The change amount ε1 of the resistance component R1 is R1(t)-R1(0) using the resistance value R1(0) at the reference time (time t=0) and the resistance value R1(t) calculated in real time. Similarly, the change amount ε2 of the resistance component R2 is R2(t)-R2(0) using the resistance value R2(0) at the reference time and the resistance value R2(t) calculated in real time.

Also for the change amounts ε1 and ε2, the change amount (first change amount) ε1 is 0 in a case where the resistance component R1 is unchanged with respect to the reference time, and the change amount (second change amount) ε2 is 0 in a case where the resistance component R2 is unchanged with respect to the reference time. In a case where the resistance component R1 increases with respect to the reference time, the change amount ε1 is a positive value, and in a case where the resistance component R1 decreases with respect to the reference time, the change amount ε1 is a negative value. Similarly, in a case where the resistance component R2 increases with respect to the reference time, the change amount ε2 is a positive value, and in a case where the resistance component R2 decreases with respect to the reference time, the change amount ε2 is a negative value.

In the present modification, reference ranges ΔX1 and ΔX2 are set for the change amounts ε1 and ε2, respectively. The reference range (first reference range) ΔX1 of the change amount ε1 includes 0 that is a value in a case where the resistance component R1 is unchanged with respect to the reference time, and the reference range (second reference range) ΔX2 of the change amount ε2 includes 0 that is a value in a case where the resistance component R2 is unchanged with respect to the reference time. In the present modification, the processing circuit 31 and the like compare the calculation result of the determination parameter, which is a parameter indicating the change of the resistance component R1 with respect to the reference time, with the reference range ΔX1, and determine regarding the degradation and operation of the electrolysis unit 2, similarly to the example of FIG. 5 and the like, except that the change amount ε1 is used as the determination parameter (first determination parameter) instead of the change rate γ1. Then, the processing circuit 31 and the like compare the calculation result of the determination parameter, which is a parameter indicating the change of the resistance component R2 with respect to the reference time, with the reference range ΔX2 and determine regarding the degradation and operation of the electrolysis unit 2 in the same manner as in the example of FIG. 5 and the like, except that the change amount ε2 is used as the determination parameter (second determination parameter) instead of the change rate γ2.

In the present modification, in a case where the change amount ε1 of the resistance component R1 exceeds the reference range ΔX1, instead of the provisional change rate γ2a, the provisional change amount ε2a is calculated as the change amount with respect to the reference time in a case where only the degradation of the membrane is assumed to have occurred in the electrolysis unit 2 for the resistance component (second resistance component) R2. The provisional change amount ε2a corresponds to a change amount of the resistance component R2 with respect to the reference time in a case where it is assumed that degradation of the cathode has not occurred in the electrolysis unit 2. In addition, the provisional change amount ε2a is a parameter indicating a change caused by the degradation of the membrane in the change of the resistance component R2 with respect to the reference time, and is calculated as a determination parameter (third determination parameter) in the determination processing.

In the present modification, instead of the difference y2b, a difference ε2b of the provisional change amount ε2a with respect to the change amount ε2 is calculated for the resistance component R2. Then, in regard to the resistance component R2, it is determined whether or not the difference ε2b of the provisional change amount ε2a with respect to the change amount ε2 is equal to or less than the reference value ε2bref, thereby determining whether or not degradation of the cathode has occurred in addition to degradation of the membrane in the electrolysis unit 2. That is, in the present modification, the processing circuit 31 and the like determine whether or not degradation of the cathode has occurred in addition to the degradation of the membrane in the electrolysis unit 2 in the same manner as in the example of FIG. 6 and the like except that the change amount ε2, the provisional change amount ε2a, the difference ε2b, and the like are used instead of the change rate γ2, the provisional change rate γ2a, the difference y2b, and the like. At this time, it is determined that only the degradation of the membrane has occurred based at least on the fact that the difference ε2b of the provisional change amount ε2a with respect to the change amount ε2 for the resistance component R2 is equal to or less than the reference value ε2bref. Then, it is determined that composite degradation of the membrane and the cathode has occurred based at least on the fact that the difference ε2b is larger than the reference value ε2bref for the resistance component R2. In addition, in the present modification, by calculating the provisional change amount ε2a and the difference ε2b, the change in the resistance component R2 with respect to the reference time is divided into a change caused by the degradation of the membrane and a change caused by the degradation of the cathode.

The parameter indicating the change with respect to the reference time used as the determination parameter (the first determination parameter and the second determination parameter) is not limited to the change rates γ1 and γ2 with respect to the reference time or the change amounts ε1 and ε2 with respect to the reference time. In a modification, as the determination parameter, a parameter obtained by adding or subtracting a constant to or from each of the change rates γ1 and γ2 or each of the change amounts ε1 and ε2 may be used, or a parameter obtained by multiplying each of the change rates γ1 and γ2 or each of the change amounts ε1 and ε2 by a constant may be used. In addition, in a modification, a parameter obtained by normalizing each of the change rates γ1 and γ2 or each of the change amounts ε1 and ε2 may be used as the determination parameter.

In the present modification, as the determination parameter (third determination parameter) indicating the change caused by the degradation of the membrane in the change of the resistance component R2 with respect to the reference time, a parameter corresponding to the determination parameter (second determination parameter) indicating the change of the resistance component R2 with respect to the reference time is calculated. For example, in a case where a parameter obtained by adding a constant to the change rate γ2 is used as the determination parameter (second determination parameter), a parameter obtained by adding a constant to the provisional change rate γ2a is used as the determination parameter (third determination parameter). When a parameter obtained by multiplying the change rate γ2 by a constant is used as the determination parameter (second determination parameter), a parameter obtained by multiplying the provisional change rate γ2a by a constant is used as the determination parameter (third determination parameter).

Also in a case where any parameter is used as the determination parameter, the parameter indicating the change in the resistance component R1 with respect to the reference time and the parameter indicating the change in the resistance component R2 with respect to the reference time are calculated as the determination parameters (the first determination parameter and the second determination parameter). At this time, for each of the resistance components R1 and R2, any of a change rate (γ1; γ2) with respect to the reference time, a parameter corresponding to the change rate (γ1; γ2), a change amount (ε1; ε2) with respect to the reference time, and a parameter corresponding to the change amount (ε1; ε2) is calculated as the determination parameter.

Even in a case where any parameter is used as the determination parameter, the determination parameter indicating the change caused by the degradation of the membrane in the change of the resistance component R2 with respect to the reference time is calculated as the determination parameter (third determination parameter). At this time, as the determination parameter (third determination parameter), a parameter corresponding to the determination parameter (second determination parameter) indicating the change in the resistance component R2 with respect to the reference time is calculated. Then, determination similar to that in the above-described approach and the like is performed using the three determination parameters (first determination parameter, second determination parameter, and third determination parameter), and for example, determination processing similar to that in the example of FIG. 5 and the example of FIG. 6 is performed.

In addition, in a modification, in the processing circuit 31 and the like, a parameter indicating a change with respect to the reference time is used as a determination parameter for one or more of the resistance components R3 and R4 in addition to the resistance components R1 and R2. Also in the present modification, the processing circuit 31 and the like determine regarding the degradation and operation of the electrolysis unit 2 based on the calculation results of the determination parameters for the resistance components R1 and R2, and perform, for example, determination processing similar to the example of FIG. 5 and the example of FIG. 6. In the present modification, in addition to the determination processing based on the determination parameters for the resistance components R1 and R2, the processing circuit 31 and the like also determine regarding the degradation and operation of the electrolysis unit 2 based on the determination parameters for one or more of the resistance components R3 and R4. In this case, the processing circuit 31 and the like determine, for example, whether or not an operational abnormality other than overheating has occurred, whether or not degradation other than degradation of the diaphragm, degradation of the cathode, composite degradation of the diaphragm and the cathode have occurred, and the like, based on the determination parameters for one or more of the resistance components R3 and R4.

In a case where the degradation of the membrane is dominant and the influence of the degradation of the cathode is small, the processing circuit 31 and the like may evaluate the degree of degradation Y of the membrane based on the resistance component R2 instead of the resistance component R1 or in addition to the resistance component R1. In this case, the processing circuit 31 and the like calculate the degree of degradation Y(t) of the membrane in real time based on, for example, the resistance value R2(t) of the resistance component R2 in real time and the relationship between the resistance component R2 and the degree of degradation Y of the membrane indicated by the line α2a in FIG. 10. In a case where the degree of degradation Y of the membrane is evaluated based on the resistance component R2 instead of the resistance component R1 or in addition to the resistance component R1, the impedance measurement time can be shortened by minimizing the frequency range for measuring the impedance except for ΔF2.

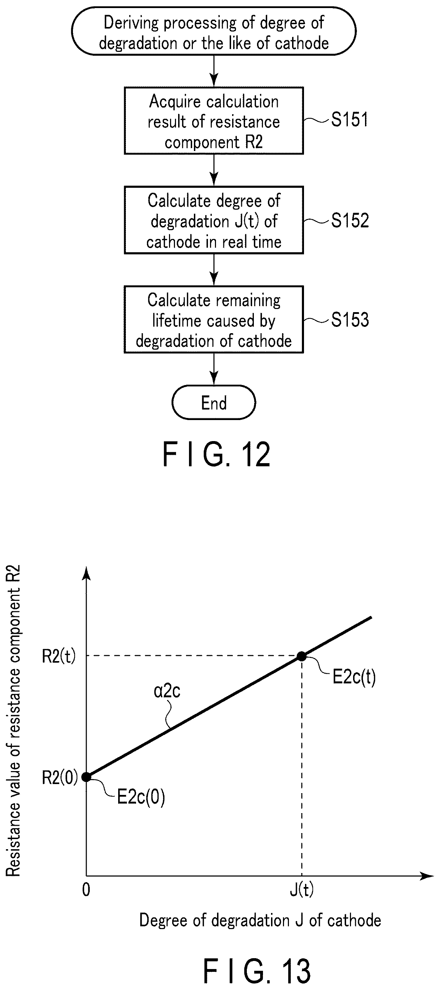

In a case where the degradation of the cathode is dominant and the influence of the degradation of the membrane is small, the processing circuit 31 and the like may ignore the influence of the degradation of the membrane on the resistance component R2 and evaluate the degree of degradation J of the cathode based on the resistance component R2. FIG. 12 is a flowchart schematically illustrating an example of deriving processing of deriving a degree of degradation or the like of the cathode of the electrolysis unit 2, which is performed by the processing circuit 31 and the like in a case where the degradation of the cathode is dominant and the influence of the degradation of the membrane is small in a modification. The processing circuit 31 and the like determine that degradation of the cathode has occurred in the electrolysis unit 2 (S116). The deriving processing of the example of FIG. 12 is performed, for example, in a case where it is determined that degradation of the cathode has occurred in S116 of the determination processing of the example of FIG. 5.

When the deriving processing of the example of FIG. 12 is started, the processing circuit 31 and the like acquire a real-time calculation result of the resistance value of the resistance component (second resistance component) R2 (S151). Then, the processing circuit 31 and the like calculate the degree of degradation J(t) of the cathode in real time based at least on the calculation result of the resistance value of the resistance component R2 (S152). In a case where the deriving processing of the example of FIG. 12 is performed, relational data indicating the relationship between the resistance component R2 and the degree of degradation J of the cathode is stored in the storage medium 32. The processing circuit 31 and the like calculate the degree of degradation J(t) of the cathode in real time using the calculation result of the resistance value of the resistance component R2 in real time, the relational data indicating the relationship between the resistance component R2 and the degree of degradation J of the cathode stored in the storage medium 32 and the like.

In a case where the deriving processing in the example of FIG. 12 is performed, a limit value R2ter corresponding to the operation limit of the electrolysis unit 2 is set for the resistance component R2. In the relational data indicating the relationship between the resistance component R2 and the degree of degradation J of the cathode, for example, in a case where the resistance component R2 is the limit value R2ter, the degree of degradation of the cathode is 100%. In the processing of S152, the degree of degradation J(t) of the cathode is calculated in real time by comparing the resistance component R2(t) in real time with the limit value R2ter of the resistance component R2.

Then, the processing circuit 31 and the like derive the remaining lifetime of the electrolysis unit 2 caused by the degradation of the cathode based on the calculation result of the resistance component R2 and the deriving result of the degree of degradation J(t) of the cathode in real time (S153). At this time, the processing circuit 31 and the like calculate a net operating time of the electrolysis unit 2 from a reference time such as a start time point of operation to a time point at which the resistance component R2 becomes the resistance value R2(t). Then, the processing circuit 31 and the like calculate the remaining time from the present time point until the resistance component R2 reaches the limit value R2ter based on the degree of degradation J(t) of the cathode in real time and the net operating time. Then, the calculated remaining time is derived as the remaining lifetime of the electrolysis unit 2 caused by the degradation of the cathode.

FIG. 13 is a schematic diagram for explaining an example of processing of deriving the degree of degradation J of the cathode of the electrolysis unit 2, which is performed by the processing circuit 31 and the like in the modification of FIG. 12. The processing described with reference to FIG. 13 corresponds to S152 in the example of FIG. 12. FIG. 13 shows a graph in which the abscissa axis represents the degree of degradation J of the cathode and the ordinate axis represents the resistance value of the resistance component (second resistance component) R2. In the example of FIG. 13, the processing circuit 31 and the like determine that the degradation of the cathode is dominant and the influence of the degradation of the membrane is small. In the example of FIG. 13, the resistance value R2(t) of the resistance component R2 in real time is calculated, and the calculation result of the resistance value R2(t) in real time is indicated by a point E2c(t). The resistance value R2(0) of the resistance component R2 at the start time point of operation as the reference time (t=0) is indicated by a point E2c(0).

In the example of FIG. 13, the relationship indicated by a line α2c is stored in the storage medium 32 as relational data indicating the relationship between the resistance component R2 and the degree of degradation J of the cathode. The relationship between the resistance component R2 and the degree of degradation J of the cathode shows the same tendency as the relationship indicated by the line α2c in a case where the influence of degradation of the membrane is small. In the example of FIG. 13, the degree of degradation J(t) of the cathode in real time is calculated based on the calculation result of the resistance value R2(t) of the resistance component R2 in real time and the relationship between the resistance component R2 and the degree of degradation J of the cathode indicated by the line α2c. In this case, the impedance measurement time can be shortened by keeping the frequency range for measuring the impedance to the minimum necessary except for ΔF2.

In the above-described approach and the like, each of the relationship between the resistance component R1 and the degree of degradation Y of the membrane indicated by the line α1 in FIG. 9, the relationship between the provisional resistance value R2a of the resistance component R2 and the degree of degradation Y of the membrane indicated by the line α2a in FIG. 10, the relationship between the difference γ2b of the provisional change rate γ2a to the change rate γ2 of the resistance component R2 and the degree of degradation J of the cathode indicated by the line α2b in FIG. 11, and the relationship between the resistance component R2 and the degree of degradation J of the cathode indicated by the line α2c in FIG. 13 is linear, but each of these relationships may be curved. In a case where each of the above-described relationships is curved, the processing circuit 31 and the like acquire the above-described relationship in advance. Then, the processing circuit 31 and the like perform the above-described calculation with reference to the relationship acquired in advance, and calculate the degree of degradation Y(t) of the membrane in real time, the degree of degradation J(t) of the cathode in real time, and the like. For example, the processing circuit 31 and the like acquire in advance the relationship between the resistance component R1 and the degree of degradation Y of the membrane. Then, the processing circuit 31 and the like calculate the degree of degradation Y(t) of the membrane in real time based on the calculation result of the resistance value R1(t) of the resistance component R1 in real time and the relationship between the resistance component R1 and the degree of degradation Y of the membrane acquired in advance.

Further, in the above-described approach and the like, the case where the carbon dioxide electrolysis unit is used as the electrolysis unit 2 has been described, but the electrolysis unit 2 to be diagnosed is not limited to the carbon dioxide electrolysis unit. Even in a case where the electrolysis unit 2 is an electrolysis unit other than the carbon dioxide electrolysis unit such as a water electrolysis unit or an ammonia electrolysis unit, it is possible to determine regarding the degradation and operation of the electrolysis unit 2 in the same manner as in any one of the above-described approaches and the like, and it is possible to diagnose the electrolysis unit 2.

In at least one of the above approaches and examples, the impedance of the electrolysis unit is measured in each of a plurality of frequency ranges including a first frequency range and a second frequency range lower in the frequency than the first frequency range. Then, based on the measurement results of the impedance in the plurality of frequency ranges, the resistance values of the first resistance component in which the influence on the impedance of the electrolysis unit becomes dominant in the first frequency range and the second resistance component in which the influence on the impedance becomes dominant in the second frequency range are calculated, and the degradation and operation of the electrolysis unit are determined based at least on the calculation results of the resistance values of the first resistance component and the second resistance component. Accordingly, it is possible to provide an electrolysis unit diagnosis method, an electrolysis unit diagnosis apparatus, an operation system, and an electrolysis unit diagnosis program that enable appropriate grasping of a degradation state and an operation status of an electrolysis unit.

The present disclosure also encompasses the following approaches of a diagnosis method of an electrolysis unit, a diagnosis apparatus of the electrolysis unit, an operation system, and a diagnosis program of the electrolysis unit:
1. A diagnosis method of an electrolysis unit (2) in which an electrochemical reaction using a feedstock occurs by input of electrical power, the diagnosis method comprising:
   measuring an impedance of the electrolysis unit (2) at one or more frequencies in each of a plurality of frequency ranges including a first frequency range (ΔF1) and a second frequency range (ΔF2) lower in frequency than the first frequency range (ΔF1);
   calculating respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
   determining regarding degradation and operation of the electrolysis unit (2) based at least on calculation results of the respective resistance values of the first resistance component (R1) and the second resistance component (R2).
2. The diagnosis method according to clause 1, further comprising:
   measuring the impedance of the electrolysis unit (2) at the one or more frequencies in a frequency range of 1 Hz or more and 1 kHz or less as the first frequency range (ΔF1); and
   measuring the impedance of the electrolysis unit (2) at the one or more frequencies in a frequency range of 0.01 Hz or more and 1 Hz or less as the second frequency range (ΔF2).
3. The diagnosis method according to clause 1 or 2, in the determining regarding the degradation and the operation of the electrolysis unit (2), further comprising:
   calculating, as a first determination parameter (γ1; ε1), a parameter indicating a change of the first resistance component (R1) with respect to a reference time based on the calculation result of the resistance value of the first resistance component (R1); and
   comparing a calculation result of the first determination parameter (γ1; ε1) with a first reference range (ΔX1) including a value in a case where the first resistance component (R1) is unchanged with respect to the reference time.
4. The diagnosis method according to clause 3, in the determining regarding the degradation and the operation of the electrolysis unit (2), further comprising:
   calculating, as a second determination parameter (γ2; ε2), a parameter indicating a change of the second resistance component (R2) with respect to the reference time based on the calculation result of the resistance value of the second resistance component (R2);
   calculating, as a third determination parameter (γ2a; ε2a), a parameter indicating a change caused by degradation of a membrane in a change of the second resistance component (R2) with respect to the reference time based on a calculation result of the resistance value of the first resistance component (R1) in a case where the first determination parameter (γ1; ε1) exceeds the first reference range (ΔX1); and
   comparing a calculation result of the second determination parameter (γ2; ε2) with a calculation result of the third determination parameter (γ2a; ε2a) in a case where the first determination parameter (γ1; ε1) exceeds the first reference range (ΔX1).
5. The diagnosis method according to clause 4, in the determining regarding the degradation and the operation of the electrolysis unit (2), further comprising:
   determining that the degradation of the membrane occurs in the electrolysis unit (2) in a case where a difference (γ2b; ε2b) between the third determination parameter (γ2a; ε2a) and the second determination parameter (γ2; ε2) is less than or equal to a reference value (γ2bref; ε2bref); and
   determining that composite degradation of the membrane and cathode occurs in the electrolysis unit (2) in a case where the difference (γ2b; ε2b) between the third determination parameter (γ2a; ε2a) and the second determination parameter (γ2; ε2) is larger than the reference value (γ2bref; ε2bref).
6. The diagnosis method according to clause 5, in the determining regarding the degradation and the operation of the electrolysis unit (2), further comprising deriving a degree of degradation (J) of the cathode in real time and a remaining lifetime of the electrolysis unit (2) caused by the degradation of the cathode based at least on the difference (y2b; ε2b) between the third determination parameter (γ2a; ε2a) and the second determination parameter (γ2; ε2) in a case where it is determined that the composite degradation of the membrane and the cathode occurs in the electrolysis unit (2).
7. The diagnosis method according to any one of clauses 4 to 6, in the determining regarding the degradation and the operation of the electrolysis unit (2), further comprising deriving a degree of degradation (Y) of the membrane in real time and a remaining lifetime of the electrolysis unit (2) caused by the degradation of the membrane based at least on a calculation result of the resistance value of the first resistance component (R1) in a case where the first determination parameter (γ1; ε1) exceeds the first reference range (ΔX1).
8. The diagnosis method according to any one of clauses 3 to 7, in the determining regarding the degradation and the operation of the electrolysis unit (2), further comprising:
   calculating, as a second determination parameter (γ2; ε2), a parameter indicating a change of the second resistance component (R2) with respect to the reference time based on the calculation result of the resistance value of the second resistance component (R2);
   comparing a calculation result of the second determination parameter (γ2; ε2) with a second reference range (ΔX2) including a value in a case where the second resistance component (R2) is unchanged with respect to the reference time in a case where the first determination parameter (γ1; ε1) falls within the first reference range (ΔX1); and
   in the comparing the calculation result of the second determination parameter (γ2; ε2) with the second reference range (ΔX2), determining that degradation of the cathode occurs in the electrolysis unit (2) based on the fact that the second determination parameter (γ2; ε2) exceeds the second reference range (ΔX2).
9. The diagnosis method according to any one of clauses 3 to 8, in the determining regarding the degradation and the operation of the electrolysis unit (2), further comprising determining that overheating has occurred in the electrolysis unit (2) based on the fact that the first determination parameter (γ1; ε1) is below the first reference range (ΔX1).
10. The diagnosis method according to any one of clauses 1 to 9, further comprising:
   in the measuring the impedance in the plurality of frequency ranges, measuring the impedance of the electrolysis unit (2) at the one or more frequencies in a third frequency range (ΔF3) higher in the frequency than the first frequency range (ΔF1) in addition to the first frequency range (ΔF1) and the second frequency range (ΔF2); and
   in the calculating the resistance value of each of the plurality of resistance components, performing calculation by adding a resistance value of a third resistance component (R3) in which an influence on the impedance becomes dominant in the third frequency range (ΔF3) to the first resistance component (R1) and the second resistance component (R2).
11. The diagnosis method according to clause 10, further comprising measuring the impedance of the electrolysis unit (2) at the one or more frequencies in a frequency range of 10 kHz or more and 100 kHz or less as the third frequency range (ΔF3).
12. A diagnosis apparatus (30) of an electrolysis unit (2) in which an electrochemical reaction using a feedstock occurs by input of electric power, the diagnosis apparatus (30) comprising a processor configured to:
   measure an impedance of the electrolysis unit (2) at one or more frequencies in each of a plurality of frequency ranges including a first frequency range (ΔF1) and a second frequency range (ΔF2) lower in frequency than the first frequency range (ΔF1);
   calculate respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
   determine regarding degradation and operation of the electrolysis unit (2) based at least on a calculation result of the resistance value of each of the first resistance component (R1) and the second resistance component (R2).
13. An operation system (1) comprising:
   the diagnosis apparatus (30) according to clause 12; and
   the electrolysis unit (2) in which a determination regarding the operation and the degradation is made by the processor of the diagnosis apparatus (30).
14. The operation system (1) according to clause 13, further comprising, as the electrolysis unit (2), a carbon dioxide electrolysis unit in which electrolysis of carbon dioxide as the feedstock occurs by input of the electric power.
15. A diagnosis program (36) of an electrolysis unit (2) in which an electrochemical reaction using a feedstock occurs by input of electric power, the program causing a computer to:
   measure an impedance of the electrolysis unit (2) at one or more frequencies in each of a plurality of frequency ranges including a first frequency range (ΔF1) and a second frequency range (ΔF2) lower in frequency than the first frequency range (ΔF1);
   calculate respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
   determine regarding degradation and operation of the electrolysis unit (2) based at least on a calculation result of the resistance value of each of the first resistance component (R1) and the second resistance component (R2).

While certain approaches have been described, these approaches have been presented by way of example only, and are not intended to limit the scope of the inventions. Indeed, the novel approaches described herein may be embodied in a variety of other forms; furthermore, various omissions, substitutions and changes in the form of the approaches described herein may be made without departing from the spirit of the inventions. The accompanying claims and their equivalents are intended to cover such forms or modifications as would fall within the scope and spirit of the inventions.

## Claims

1. A diagnosis method of an electrolysis unit (2) in which an electrochemical reaction using a feedstock occurs by input of electrical power, the diagnosis method comprising:
measuring an impedance of the electrolysis unit (2) at one or more frequencies in each of a plurality of frequency ranges including a first frequency range (ΔF1) and a second frequency range (ΔF2) lower in frequency than the first frequency range (ΔF1);
calculating respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
determining regarding degradation and operation of the electrolysis unit (2) based at least on calculation results of the respective resistance values of the first resistance component (R1) and the second resistance component (R2).

2. The diagnosis method according to claim 1, further comprising:
measuring the impedance of the electrolysis unit (2) at the one or more frequencies in a frequency range of 1 Hz or more and 1 kHz or less as the first frequency range (ΔF1); and
measuring the impedance of the electrolysis unit (2) at the one or more frequencies in a frequency range of 0.01 Hz or more and 1 Hz or less as the second frequency range (ΔF2) .

3. The diagnosis method according to claim 1 or 2, in the determining regarding the degradation and the operation of the electrolysis unit (2), further comprising:
calculating, as a first determination parameter (γ1; ε1), a parameter indicating a change of the first resistance component (R1) with respect to a reference time based on the calculation result of the resistance value of the first resistance component (R1); and
comparing a calculation result of the first determination parameter (γ1; ε1) with a first reference range (ΔX1) including a value in a case where the first resistance component (R1) is unchanged with respect to the reference time.

4. The diagnosis method according to claim 3, in the determining regarding the degradation and the operation of the electrolysis unit (2), further comprising:
calculating, as a second determination parameter (γ2; ε2), a parameter indicating a change of the second resistance component (R2) with respect to the reference time based on the calculation result of the resistance value of the second resistance component (R2);
calculating, as a third determination parameter (γ2a; ε2a), a parameter indicating a change caused by degradation of a membrane in a change of the second resistance component (R2) with respect to the reference time based on a calculation result of the resistance value of the first resistance component (R1) in a case where the first determination parameter (γ1; ε1) exceeds the first reference range (ΔX1); and
comparing a calculation result of the second determination parameter (γ2; ε2) with a calculation result of the third determination parameter (γ2a; ε2a) in a case where the first determination parameter (γ1; ε1) exceeds the first reference range (ΔX1).

5. The diagnosis method according to claim 4, in the determining regarding the degradation and the operation of the electrolysis unit (2), further comprising:
determining that the degradation of the membrane occurs in the electrolysis unit (2) in a case where a difference (γ2b; ε2b) between the third determination parameter (γ2a; ε2a) and the second determination parameter (γ2; ε2) is less than or equal to a reference value (γ2bref; ε2bref); and
determining that composite degradation of the membrane and cathode occurs in the electrolysis unit (2) in a case where the difference (y2b; ε2b) between the third determination parameter (γ2a; ε2a) and the second determination parameter (γ2; ε2) is larger than the reference value (γ2bref; ε2bref).

6. The diagnosis method according to claim 5, in the determining regarding the degradation and the operation of the electrolysis unit (2), further comprising deriving a degree of degradation (J) of the cathode in real time and a remaining lifetime of the electrolysis unit (2) caused by the degradation of the cathode based at least on the difference (γ2b; ε2b) between the third determination parameter (γ2a; ε2a) and the second determination parameter (γ2; ε2) in a case where it is determined that the composite degradation of the membrane and the cathode occurs in the electrolysis unit (2).

7. The diagnosis method according to any one of claims 4 to 6, in the determining regarding the degradation and the operation of the electrolysis unit (2), further comprising deriving a degree of degradation (Y) of the membrane in real time and a remaining lifetime of the electrolysis unit (2) caused by the degradation of the membrane based at least on a calculation result of the resistance value of the first resistance component (R1) in a case where the first determination parameter (γ1; ε1) exceeds the first reference range (ΔX1).

8. The diagnosis method according to any one of claims 3 to 7, in the determining regarding the degradation and the operation of the electrolysis unit (2), further comprising:
calculating, as a second determination parameter (γ2; ε2), a parameter indicating a change of the second resistance component (R2) with respect to the reference time based on the calculation result of the resistance value of the second resistance component (R2);
comparing a calculation result of the second determination parameter (γ2; ε2) with a second reference range (ΔX2) including a value in a case where the second resistance component (R2) is unchanged with respect to the reference time in a case where the first determination parameter (γ1; ε1) falls within the first reference range (ΔX1); and
in the comparing the calculation result of the second determination parameter (γ2; ε2) with the second reference range (ΔX2), determining that degradation of the cathode occurs in the electrolysis unit (2) based on the fact that the second determination parameter (γ2; ε2) exceeds the second reference range (ΔX2).

9. The diagnosis method according to any one of claim 3 to 8, in the determining regarding the degradation and the operation of the electrolysis unit (2), further comprising determining that overheating has occurred in the electrolysis unit (2) based on the fact that the first determination parameter (γ1; ε1) is below the first reference range (ΔX1).

10. The diagnosis method according to any one of claims 1 to 9, further comprising:
in the measuring the impedance in the plurality of frequency ranges, measuring the impedance of the electrolysis unit (2) at the one or more frequencies in a third frequency range (ΔF3) higher in the frequency than the first frequency range (ΔF1) in addition to the first frequency range (ΔF1) and the second frequency range (ΔF2); and
in the calculating the resistance value of each of the plurality of resistance components, performing calculation by adding a resistance value of a third resistance component (R3) in which an influence on the impedance becomes dominant in the third frequency range (ΔF3) to the first resistance component (R1) and the second resistance component (R2).

11. The diagnosis method according to claim 10, further comprising measuring the impedance of the electrolysis unit (2) at the one or more frequencies in a frequency range of 10 kHz or more and 100 kHz or less as the third frequency range (ΔF3).

12. A diagnosis apparatus (30) of an electrolysis unit (2) in which an electrochemical reaction using a feedstock occurs by input of electric power, the diagnosis apparatus (30) comprising a processor configured to:
measure an impedance of the electrolysis unit (2) at one or more frequencies in each of a plurality of frequency ranges including a first frequency range (ΔF1) and a second frequency range (ΔF2) lower in frequency than the first frequency range (ΔF1);
calculate respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
determine regarding degradation and operation of the electrolysis unit (2) based at least on a calculation result of the resistance value of each of the first resistance component (R1) and the second resistance component (R2).

13. An operation system (1) comprising:
the diagnosis apparatus (30) according to claim 12; and
the electrolysis unit (2) in which a determination regarding the operation and the degradation is made by the processor of the diagnosis apparatus (30).

14. The operation system (1) according to claim 13, further comprising, as the electrolysis unit (2), a carbon dioxide electrolysis unit in which electrolysis of carbon dioxide as the feedstock occurs by input of the electric power.

15. A diagnosis program (36) of an electrolysis unit (2) in which an electrochemical reaction using a feedstock occurs by input of electric power, the program causing a computer to:
measure an impedance of the electrolysis unit (2) at one or more frequencies in each of a plurality of frequency ranges including a first frequency range (ΔF1) and a second frequency range (ΔF2) lower in frequency than the first frequency range (ΔF1);
calculate respective resistance values of a plurality of resistance components of the electrolysis unit (2) including a first resistance component (R1) in which an influence on the impedance of the electrolysis unit (2) becomes dominant in the first frequency range (ΔF1) and a second resistance component (R2) in which an influence on the impedance becomes dominant in the second frequency range (ΔF2) based on measurement results of the impedance in the plurality of frequency ranges; and
determine regarding degradation and operation of the electrolysis unit (2) based at least on a calculation result of the resistance value of each of the first resistance component (R1) and the second resistance component (R2).
